(19) Europäisches Patentamt
European Patent Office
Office européen des brevets

(11) **EP 2 252 727 B1**

(12) **EUROPÄISCHE PATENTSCHRIFT**

(45) Veröffentlichungstag und Bekanntmachung des Hinweises auf die Patenterteilung:
**16.11.2022 Patentblatt 2022/46**

(21) Anmeldenummer: **09722137.8**

(22) Anmeldetag: **12.03.2009**

(51) Internationale Patentklassifikation (IPC):
**C25D 1/08** *(2006.01)* **C25D 5/18** *(2006.01)*

(52) Gemeinsame Patentklassifikation (CPC):
**C25D 1/006; B01J 19/0093; B01J 23/42;
B01J 23/72; B01J 35/0006; B22F 1/0547;
B22F 3/002; B81C 99/0085; B82Y 15/00;
B82Y 30/00; C25D 1/08; C25D 5/18; C25D 5/617;**
B01J 2219/00783; B01J 2219/00835; (Forts.)

(86) Internationale Anmeldenummer:
**PCT/EP2009/001778**

(87) Internationale Veröffentlichungsnummer:
**WO 2009/115228 (24.09.2009 Gazette 2009/39)**

(54) **NANODRAHT-STRUKTURELEMENT**

NANOWIRE STRUCTURAL ELEMENT

ÉLÉMENT STRUCTUREL À NANOFILS

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **20.03.2008 DE 102008015333**

(43) Veröffentlichungstag der Anmeldung:
**24.11.2010 Patentblatt 2010/47**

(73) Patentinhaber: **GSI Helmholtzzentrum für Schwerionenforschung GmbH 64291 Darmstadt (DE)**

(72) Erfinder:
• **CORNELIUS, Thomas 38000 Grenoble (FR)**
• **ENSINGER, Wolfgang 64839 Münster (DE)**
• **NEUMANN, Reinhard 69221 Dossenheim (DE)**
• **RAUBER, Markus 64289 Darmstadt (DE)**

(74) Vertreter: **Blumbach · Zinngrebe Patentanwälte PartG mbB Alexandrastraße 5 65187 Wiesbaden (DE)**

(56) Entgegenhaltungen:
**US-A- 5 911 863 US-A1- 2006 134 392**

• **Rauber, M.: "Herstellung und Charakterisierung von Edelmetall-Nanodraht-Arrays - Diplomarbeit" 31. August 2007 (2007-08-31), Philipps-Universität Marburg - GSI Helmholtzzentrum für Schwerionenforschung GmbH , XP002547634 Abbildungen 2.2, 2.11, 2.12, 4.15-4.26 Seite 8, Zeile 1 - Seite 13, Zeile 26 Seite 14, Zeile 1 - Seite 18, Zeile 4 Seite 26, Zeile 3 - Seite 28, Zeile 10 Seite 45, Zeile 9 - Seite 50, Zeile 2 Seite 54, Zeile 1 - Seite 57, Zeile 14 Seite 61, Zeilen 3-10**
• **LINDBERG M; HJORT K: "A comprehensive study of ion track enabled high aspect ratio microstructures in flexible circuit boards" MICROSYSTEM TECHNOLOGIES, BERLIN, DE, Bd. 10, 1. Januar 2004 (2004-01-01), Seiten 608-621, XP003020386 ISSN: 0946-7076**

- URSACHE ANDREI; GOLDBACH JAMES; RUSSELL THOMAS; TUOMINEN MARK: "Pulse electrodeposition and electrochemical quartz crystal microbalance techniques for high perpendicular magnetic anisotropy cobalt nanowire arrays" JOURNAL OF APPLIED PHYSICS, AMERICAN INSTITUTE OF PHYSICS. NEW YORK, US, Bd. 97, Nr. 10, 12. Mai 2005 (2005-05-12), Seiten 10J322-10J322, XP012069887 ISSN: 0021-8979
- NIELSCH, K. ET AL: "Uniform Nickel Deposition into Ordered Alumina Pores by Pulsed Electrodeposition" ADVANCED MATERIALS, Bd. 12, Nr. 8, 4. April 2000 (2000-04-04), Seiten 582-586, XP002548117 in der Anmeldung erwähnt
- LINDEBERG M ET AL: "Interconnected nanowire clusters in polyimide for flexible circuits and magnetic sensing applications", SENSORS AND ACTUATORS A: PHYSICAL, ELSEVIER BV, NL, vol. 105, no. 2, 15 July 2003 (2003-07-15) , pages 150-161, XP004428584, ISSN: 0924-4247, DOI: 10.1016/S0924-4247(03)00088-8

(52) Gemeinsame Patentklassifikation (CPC): (Forts.)
B01J 2219/00846; B01J 2219/00853;
B01J 2219/0086; B01J 2219/00873;
B81B 2201/0292; B81B 2201/051

## Beschreibung

### Gebiet der Erfindung

Die Erfindung betrifft ein Nanodraht-Strukturelement, ein Verfahren zu dessen Herstellung und ein Mikroreaktorsystem, insbesondere ein Mikrokatalysatorsystem.

### Hintergrund der Erfindung

K. Jähnisch et al. haben in "Chemistry in Microstructured Reactors", Ang. Chem. Int. Ed. 2004, 43, 406-446 die Vorteile mikrostrukturierter Bauelemente für chemische Reaktionen und analytische Zwecke demonstriert. Dies führte zu einem Gewinn an Bedeutung solcher Systeme für die chemische Synthese und Analyse. Im Vergleich zu konventionellen Reaktoren besitzen diese Mikrostrukturreaktoren ein sehr großes Oberflächen-Volumen-Verhältnis, was die Wärmeaustauschleistung sowie den Ablauf des Stofftransportes positiv beeinflusst (vgl. O. Wörz et al. "Microreactors - a New Efficient Tool for Reactor Development", Chem. Eng. Technol. 2001, 24, 138-142).

Es wurden bereits viele bekannte Reaktionen in Mikrostrukturreaktoren durchgeführt, unter anderem auch viele katalytische Reaktionen. Hierbei ist es gleichgültig, ob es sich um Flüssigphasen-, Gasphasen- oder Gas-Flüssigphasen-Reaktionen handelt. Um die potentielle Aktivität des Katalysators nutzen zu können, wird das Katalysatormaterial in mikrostrukturierte Systeme mit verschiedenen geometrischen Formen integriert. Geht man vom einfachsten Fall aus, so besteht das Reaktormaterial, welches zum Bau des Mikroreaktors verwendet wird, selbst aus der katalytisch aktiven Substanz (vgl. M. Fichtner, "Microstructured Rhodium Catalysts for the Partial Oxidation of Methane to Syngas under Pressure", Ind. Eng. Chem. Res. 2001, 40, 3475-3483). Das hat jedoch zur Folge, dass die Katalysatoroberfläche auf die Reaktorwand beschränkt ist. Dieser Nachteil wird teilweise mit Hilfe optimierter Katalysator/Träger-Systeme umgangen. Meist beinhalten die heutigen Mikrostrukturreaktoren kleine Partikel oder Pulver, die in einen Kanal eingetragen wurden.

Es kommen aber auch Katalysator-Filamente, Drähte und Membranen zum Einsatz (vgl. G. Veser, "Experimental and Theoretical Investigation of H2 Oxidation in a High-Temperature Catalytic Microreactor", Chem. Eng. Sci. 2001, 56, 1265-1273). Metallische Nanostrukturen, insbesondere solche aus Edelmetallen, sind aufgrund ihres großen Verhältnisses von Oberfläche zu Masse, was mit geringeren Herstellungskosten verbunden ist, in der heterogenen Katalyse bekannt (vgl. R. Narayanan et al. "Catalysis with Transition Metal Nanoparticles in Colloidal Solution: Nanoparticle Shape Dependence and Stability" J. Chem. Phys. B, 2005, 109, 12663-12676).

Ursprünglich konzentrierte sich die Forschung in den Nanowissenschaften auf die Untersuchung isotroper Metallpartikel, weswegen ihre katalytischen Eigenschaften gut erforscht sind. Bis heute wurden aber auch viele eindimensionale Nanostrukturen in Hinblick auf ihren Einsatz in der heterogenen Katalyse analysiert. Ein großes Problem stellt jedoch deren Immobilisierung dar. Aus Z. Chen et al., "Supportless Pt and PtPd Nanotubes as Electrocatalysts for Oxygen-Reduction Reactions", Angew. Chem. 2007, 119, S. 4138-4141, ist bekannt, Nanostrukturen auf einen Träger aufzubringen oder in poröse Materialien wie z. B. Nafion einzulagern, was jedoch zwangsläufig zu einer Abnahme der nutzbaren Katalysatoroberfläche führt. Zudem muss beachtet werden, dass die katalytische Aktivität aufgrund von Diffusionsprozessen von der Verteilung des Katalysatormaterials abhängt. Demnach erhöhen die Nanopartikel das Oberflächen-Volumen-Verhältnis zwar drastisch, jedoch fällt die Langzeitstabilität solcher Reaktoren aus folgenden Gründen relativ gering aus:

1. Verlust des Kontaktes von Nanopartikeln aufgrund von Korrosion des Trägers,
2. Auflösung und erneute Abscheidung oder Ostwald-Reifung,
3. Aggregation der Nanopartikel, um die Oberflächenenergie zu minimieren und
4. Auflösung der Nanopartikel und Migration der löslichen Ionen.

Parallel ausgerichtete Draht- und Röhrenanordnungen wurden bereits als Glucose-Sensor (J. H. Yuan, et al., "Highly ordered Platinum-Nanotubule Arrays for Amperometric Glucose Sensing", Adv. Funct. Mater 2005, 15, 803), als Elektrokatalysator z. B. in der Alkoholoxidation (H. Wang et al., "Pd nanowire arrays as electrocatalysts for ethanol electrooxidation", Electrochem. Commun. 2007, 9, 1212-1216) und der Wasserstoffperoxidreduktion (H. M. Zhang et al., "novel electrocatalytic activity in layered Ni-Cu nanowire arrays", Chem. Commun. 2003, 3022) eingesetzt. In diesen Fällen sind die Nanostrukturen jedoch freistehend, so dass die Anordnung offen und nicht stabil ist.

Nielsch et al. berichten in "Uniform Nickel Deposition into ordered Alumina pores by pulsed electrodeposition", Adv. Mater. 2000, 12, 582-586, dass gepulste Abscheidung zur Abscheidung von dünnen, metallischen Filmen genutzt wird. Nielsch et al. berichten in "Uniform Nickel Deposition into ordered Alumina pores by pulsed electrodeposition", Adv. Mater. 2000, 12, 582-586, dass gepulste Abscheidung zur Abscheidung von dünnen, metallischen Filmen genutzt wird.

Die Veröffentlichungen von M. Lindeberg "A comprehensive study of ion track enabled high aspect ratio microstructures in flexible circuit boards" MICROSYSTEM TECHNOLOGIES, BERLIN, DE, Bd. 10, 1. Januar 2004 (2004-01-01), Seiten 608-621, sowie "Interconnected nanowire clusters in polyimide for flexible circuits and magnetic sensing applications", SENSORS AND ACTUATORS A: PHYSICAL, ELSEVIER BV, NL, Bd. 105, Nr. 2, 15. Juli 2003 (2003-07-15), Seiten 150-161, behandeln ebenfalls grundsätzlich die Erzeugung von Nanodrähten unter Anwendung von Ionenspuren. In demselben Feld zeigt die Druckschrift US 2006/134392 A1 eine Anzahl von vertikal angeordneten Nanodrähten zwischen zwei elektrisch leitfähigen Schichten.

Alles in allem besteht auf dem Gebiet der Nanotechnologie aber noch erhebliches weiteres Innovationspotential.

Allgemeine Beschreibung der Erfindung

Die Erfindung hat sich die Aufgabe gestellt, ein neuartiges Nanodraht-Strukturelement zur Verfügung zu stellen, welches vielseitig anwendbar ist.

Eine weitere Aufgabe der Erfindung ist es, ein Verfahren bereit zu stellen, welches die Herstellung eines Nanodraht-Strukturelements mit einer Hohlraumstruktur ermöglicht.

Eine weitere Aufgabe der Erfindung ist es, ein Nanodraht-Strukturelement bereit zu stellen, welches eine Hohlraumstruktur mit großer spezifischer Oberfläche aufweist und welches sich z.B. als Katalysatorelement eignet.

Die Aufgabe der Erfindung wird durch den Gegenstand der unabhängigen Ansprüche gelöst. Vorteilhafte Weiterbildungen der Erfindung sind in den Unteransprüchen definiert.

Es wird ein Verfahren zur Herstellung eines Nanodraht-Strukturelements bereit gestellt, welches ein zwischen zwei Deckschichten angeordnetes Nanodraht-Array umfasst, derart dass eine säulenartig von den Nanodrähten durchsetzte Hohlraumstruktur entsteht. Es wird ein sogenanntes templatbasiertes Verfahren wie folgt angewendet.

In einem ersten Verfahrensschritt (a) wird zunächst eine dielektrische Templatfolie bereitgestellt. Je nach dem, welches Verfahren zur Erzeugung der Nanoporen verwendet werden soll, ist die Templatfolie z.B. eine gewöhnliche Kunststofffolie, insbesondere eine Polymerfolie, sie kann aber auch eine Glas- oder Glimmerfolie oder eine Aluminiumfolie sein.

In einem Verfahrensschritt (b) wird auf eine erste Seite der Templatfolie eine erste flächig geschlossene elektrisch leitfähige Deckschicht, vorzugsweise eine Metallschicht aufgebracht. Vorzugsweise wird zunächst eine dünne Metallschicht, z.B. Goldschicht aufgesputtert und nachfolgend wird diese Goldschicht elektrochemisch z.B. mit einer Kupferschicht verstärkt. Dies hat den Vorteil, dass zunächst eine relativ dünne Schicht aufgesputtert werden kann. Die erste leitfähige Deckschicht hat eine Doppelfunktion, sie dient einerseits als Kathode für das nachfolgende elektrochemische Abscheideverfahren und andererseits später als stabile geschlossene Deckschicht des zu erzeugenden Nanodraht-Strukturelements, d.h. sie verbleibt als integraler Bestandteil des zu erzeugenden Nanodraht-Strukturelements und wird hiervon nicht wieder entfernt.

In einem Verfahrensschritt (c) wird in der Templatfolie eine Vielzahl von Nanoporen erzeugt, die insbesondere die Templatfolie vollständig quer zur Oberfläche der Templatfolie durchdringen. In Bezug auf die Schritte (b) und (c) soll durch die Buchstaben keine spezifische Reihenfolge impliziert werden. Diesbezüglich sind nämlich verschiedene Alternativen für die

Verfahrensreihenfolge möglich, wie sich nachfolgend aus der weiteren Beschreibung ergibt.

In einem nachfolgenden Teilschritt (d1) werden, beginnend auf der Innenseite der ersten Deckschicht, in den Nanoporen innerhalb der Templatfolie Nanodrähte mittels elektrochemischer Abscheidung gezüchtet, d.h. die Nanoporen werden von der ersten Deckschicht mittels der elektrochemischen Abscheidung gefüllt, wobei die Nanodrähte in den Nanoporen wachsen. Hierzu wird die mit den Poren durchsetzte und einseitig leitfähig beschichtete dielektrische Folie in eine elektrochemische Abscheidevorrichtung eingesetzt, wobei die erste Deckschicht als Kathode für den elektrochemischen Abscheidevorgang der Nanodrähte dient. Mittels elektrochemischer Abscheidung von Metallionen werden nun die Nanodrähte in den Nanoporen gezüchtet, wobei die Nanodrähte aus Metall innerhalb der Nanoporen, insbesondere unmittelbar, auf die erste Deckschicht aufwachsen und dabei mit der ersten Deckschicht fest verwachsen. Die Nanodrähte weisen dabei einen Durchmesser von kleiner oder gleich 2000 nm auf.

Ein solches Verfahren der Nanodrahterzeugung ist grundsätzlich bekannt, es wird z.B. auf T. W. Cornelius et al., "Controlled fabrication of poly- and single-crystalline bismuth nanowires", Nanotechnology 2005, 16, S. 246-249; und auf die Dissertationen von Thomas Walter Cornelius, GSI, 2006; Florian Maurer, GSI, 2007, verwiesen.

Bei diesen Verfahren wurden allerdings lediglich einzelne Nanodrähte gewonnen. Im Gegensatz dazu kann mit der vorliegenden Erfindung ein selbsttragendes Strukturelement hergestellt werden, bei welchem die erste Deckschicht erhalten und mit den Nanodrähten verbunden bleibt und zusätzlich in einem Teilschritt (d2) eine zweite flächig geschlossene elektrisch leitfähige Deckschicht auf der gegenüberliegenden zweite Seite der Templatfolie aufgebracht wird, die ebenfalls zu einem integralen Bestandteil des zu erzeugenden Nanodraht-Strukturelements wird.Die zweite Deckschicht verwächst wie die erste Deckschicht fest mit den Nanodrähten und wird nicht mehr entfernt.

Demnach verbinden die Nanodrähte wie ein Säulenarray die beiden Deckschichten miteinander. In dem Verfahrensstand unmittelbar nach dem Erzeugen der zweiten Deckschicht ist zunächst noch die Templatfolie vorhanden, die sandwichartig zwischen den beiden Deckschichten eingeschlossen ist, da beide Deckschichten unmittelbar auf die Templatfolie aufgebracht werden. Die Templatfolie ist in diesem Verfahrensstand wie bei einer Armierung von den Nanodrähten durchsetzt.

Wenn die sandwichartige Anordnung bestehend aus den beiden Deckschichten und der von massiven Nanodrähten durchsetzten Templatfolie soweit fertiggestellt ist, dass beide Deckschichten eine hinreichende Dicke und damit Stabilität aufweisen, wird in einem Schritt (e) die Templatfolie zwischen den beiden Deckschichten, insbesondere chemisch, aufgelöst und damit eine Hohlraumstruktur zwischen den beiden Deckschichten unter Erhaltung der Nanodrähte freigelegt. Ist die Templatfolie eine Kunststofffolie kann diese z.B. mit einem Lösungsmittel aufgelöst werden. Andere Folien wie z.B. Glas, Glimmer werden z.B. mit Flusssäure (HF) aufgelöst. Zum Auflösen von Aluminiumoxid sind verdünnte Basen wie z.B. NaOH ausreichend. Die Templatfolie wird beim Auflösen zumindest in so kleine Bestandteile zerlegt, dass diese Bestandteile aus dem von den Nanodrähten durchsetzten Hohlraum zwischen den beiden Deckschichten entfernt werden können, ohne die Deckschichten und die Nanodrähte zu beschädigen.

Nach der vollständigen Entfernung der Templatfolie bleibt demnach ein strukturstabiles Hohlraum-Bauelement übrig, bei welchem die Vielzahl der Nanodrähte die beiden Deckschichten miteinander verbinden und parallel voneinander beabstandet halten. Es ist also das jeweils erste Ende der Nanodrähte integral mit der ersten Deckschicht verbunden und das jeweils zweite Ende ist integral mit der zweiten Deckschicht verbunden. Demnach wird durch die Entfernung der Templatfolie ein strukturierter Hohlraum zwischen den beiden Deckschichten freigelegt, wobei der Hohlraum beidseits von den Deckschichten begrenzt und von den parallelen Nanodrähten quer zu den beiden Deckschichten durchzogen wird. Die Zwischenräume zwischen den Nanodrähten und zwischen beiden Deckschichten sind in der Ebene der beiden Deckschichten miteinander verbunden, so dass in der Ebene der Deckschichten eine zweidimensional offenzellige Hohlraumstruktur definiert wird. Mit anderen Worten wird ein stabiles, selbsttragendes Nanodraht-Strukturelement gebildet, das aus den beiden geschlossenen Deckschichten und dem sandwichartig zwischen den beiden Deckschichten eingeschlossenen und mit diesen verbundenem, säulenartigen Nanodraht-Array besteht.

Dieses Nanodraht-Strukturelement mit beidseits flächig geschlossenem Nanodraht-Array, bzw. schichtartiger von dem Nanodraht-Array durchzogener Hohlraumstruktur eignet sich in hervorragender Weise z.B. als Mikroreaktor-Bauelement, insbesondere als Mikrokatalysator-Bauelement für die heterogene Katalyse. Außerdem besitzt das Nanodraht-Strukturelement eine große Langzeitstabilität, da die Nanodrähte beidseits fest verankert sind und nicht z.B. lose in Mikrokanälen liegen.

Um eine stabile Verbindung zwischen dem Nanodraht-Array und der zweiten Deckschicht zu erzielen, wird der elektrochemische Abscheideprozess der Nanodrähte zumindest so lange fortgeführt, bis sich auf der zweiten Seite der Templatfolie Kappen auf den Nanodrähten ausgebildet haben. Zur Erzeugung der zweiten Deckschicht werden weiter insbesondere folgende zwei Möglichkeiten vorgeschlagen:

Der elektrochemische Abscheidevorgang wird gemäß dem erfindungsgemäßen Verfahren nach dem vollständigen Auffüllen der Nanoporen weiter fortgeführt, wobei auf der zweiten Seite der Templatfolie zunächst Kappen auf den Nanodrähten wachsen. Bei weiterer Fortführung des elektrochemischen Abscheidevorgangs wachsen die Kappen zu einer flächig geschlossenen Schicht zusammen und diese flächig geschlossene Schicht gewinnt mit zunehmender Abscheidedauer an Dicke. Man kann also nun den elektrochemischen Abscheidevorgang mit dem die Nanodrähte erzeugt oder gezüchtet werden, demnach einfach so lange fortführen, bis die zweite Deckschicht vollständig in Form einer hinreichend dicken, stabilen, flächig geschlossenen Schicht gewachsen ist. Hierbei bilden dann die Nanodrähte und die gesamte zweite Deckschicht eine einstückig gewachsene Struktur aus elektrochemisch abgeschiedenem Material. Es werden also die Teilschritte (d1) und (d2) als Teilschritte desselben elektrochemischen Abscheidevorgangs mit demselben elektrisch leitfähigen Material durchgeführt.

Alternativ wird der elektrochemische Abscheidevorgang gemäß Teilschritt (d1) zur Erzeugung der Nanodrähte solange fortgeführt, bis auf der zweiten Seite der Templatfolie Kappen auf den Nanodrähten wachsen und die Kappen zumindest teilweise zusammenwachsen, aber noch keine stabile zweite Deckschicht erzeugt ist und dann erst einmal beendet. Die Fertigstellung der zweiten Deckschicht erfolgt erst in einem separaten zweiten nachfolgenden Abscheidevorgang, wobei eine flächig geschlossene weitere Schicht auf den zumindest teilweise zusammengewachsenen Kappen abgeschieden wird, so dass die stabile zweite Deckschicht dann aus der zweischichtigen Anordnung aus den zumindest teilweise zusammengewachsenen Kappen und der flächig geschlossenen weiteren Schicht entsteht. Die zumindest teilweise zusammengewachsenen Kappen bilden somit eine erste Teilschicht der zweiten Deckschicht, und die weitere Schicht bildet eine zweite Teilschicht der zweiten Deckschicht. Der separate Abscheidevorgang kann ebenfalls eine elektrochemische Abscheidung sein, kann aber auch ein PVD-Verfahren wie z.B. Aufdampfen oder Aufsputtern umfassen. Auch wenn der separate Abscheidevorgang eine elektrochemische Abscheidung ist, kann für die zweite Teilschicht ein anderes Material als für die Nanodrähte und die Kappen verwendet werden. Besonders hat sich bewährt, die Nanodrähte und die Kappen mit einem gepulsten elektrochemischen Abscheideverfahren zu erzeugen und die zweite Teilschicht mit einem Gleichstromverfahren elektrochemisch abzuscheiden. Beispielsweise werden die Nanodrähte und die Kappen mit einer Umkehrpulsabscheidung aus Platin erzeugt und die zweite Teilschicht mit Gleichstromabscheidung aus Kupfer. Hierdurch können die Abscheidezeit verkürzt und die Materialkosten gesenkt werden.

Demnach wird die zweite Deckschicht gemäß Teilschritt (d2) teilweise oder vollständig durch elektrochemische Abscheidung eines elektrisch leitfähigen Materials, vorzugsweise Metalls auf der zweiten Seite der Templatfolie erzeugt, so dass die zweite Deckschicht mit den Nanodrähten fest verwachsen ist.

Zumindest die Nanodrähte und die zumindest teilweise zusammengewachsenen Kappen werden demnach vorzugsweise gepulst abgeschieden. Die gepulste Abscheidung umfasst zumindest folgende Alternativen:

1) Die Abscheidung erfolgt mittels Pulsabscheidung, d.h. Abscheidepulse und abscheidungsfreie Diffusionszeiträume wechseln sich ab.
2) Die Abscheidung erfolgt mittels Umkehrpulsabscheidung, d.h. Abscheidepulse und anodische Gegenpulse wechseln sich ab.

Beide Alternativen haben den Vorteil, dass in den Pausen zwischen den Abscheidepulsen in der Elektrolytlösung Ionen in die Nanoporen nachdiffundieren können, was zu einem einheitlicherem Wachstum der Nanodrähte und der aus den Kappen zusammengewachsenen Schicht führt.

Die erste Deckschicht kann einstückig mittels eines Beschichtungsverfahrens, z.B. PVD, Aufdampfen oder Sputtern aufgebracht werden. Vorzugsweise wird die erste Deckschicht allerdings zumindest zweischichtig erzeugt, wobei die erste Teilschicht mittels PVD, z. B. Aufsputtern oder Aufdampfen, abgeschieden wird und diese erste Teilschicht dann mittels elektrochemischer Abscheidung gegebenenfalls mit einer zweiten Teilschicht aus einem anderen Material, z.B. Kupfer auf Gold, verstärkt wird.

Derzeit werden zwei grundsätzlich bekannte Verfahren zur Erzeugung der Nanoporen in der Templatfolie in Betracht gezogen, erstens Ionenstrahl-induziertes Ätzen und zweitens Anodisieren einer Aluminiumfolie.

Bezüglich der Herstellung von Nanoporen-Arrays in anodischem Aluminiumoxid wird auf A.P. Li et al. "Hexagonal Pore Arrays with a 50-420 nm Interpore Distance Formed by Self-Organization in Anodic Alumina", Journal of Applied Physics, 84-11, 1998, S. 6023-6026, und einen Review-Artikel von J.W. Diggle, Thomas C. Downie, und C.W. Goulding; S. 365-405 DOI: 10.1021/cr60259a005 verwiesen Derartige anodische Aluminiumoxid-Template haben die besondere Eigenschaft, dass die Nanoporen in Form eines hexagonalen Musters regelmäßig angeordnet sind.

Bei der durch den Ionenstrahl induzierten Veränderung des Ätzverhaltens wird hingegen eine stochastische Verteilung der Nanoporen erzielt. Die Herstellung von ionenspurgeätzten Templaten umfasst das Erzeugen der Nanoporen mit folgenden Teilschritten:

Zunächst wird eine handelsübliche Kunststofffolie, z.B. eine Polymerfolie, mit energetischer Strahlung, insbesondere mit einem hochenergetischen Ionenstrahl, wie er z.B. an den Beschleunigeranlagen der Gesellschaft für Schwerionenforschung mbH in Darmstadt verfügbar ist, bestrahlt (c1). Durch die Bestrahlung entsteht eine Vielzahl von latenten Spuren, die die Templatfolie durchsetzen. Die Spuren sind dadurch gekennzeichnet, dass die Polymerstruktur der Folie entlang der Trajektorie jedes einzelnen Bestrahlungsions zerstört wird. Im unaufgeätzten Zustand bezeichnet man diese Spuren als "latent". Sie werden später mittels eines Ätzverfahrens zu sichtbaren Spuren, den Nanoporen aufgeweitet (c2).

Bevorzugt wird zunächst die Ionenbestrahlung vorgenommen und nachfolgend, aber noch vor dem Ätzen, die erste Deckschicht aufgebracht. Erst nachdem die erste Deckschicht auf der Templatfolie aufgebracht ist, werden die Nanoporen aus den latenten ioneninduzierten Spuren geätzt. Insbesondere wird also die leitfähige Metallschicht auf die Templatfolie aufgebracht und diese wird elektrochemisch verstärkt, bevor die latenten Ionenspuren dem chemischen Ätzprozess unterworfen werden. Auf diese Weise wird verhindert, dass sich Material der ersten Deckschicht in den Poren abscheiden kann. Hierdurch konnte eine verbesserte mechanische Stabilität des erzeugten Nanodraht-Strukturelements erreicht werden. Zudem sind die Poren streng zylindrisch und weisen keine Verengung an den beiden Enden auf.

Das Ergebnis des vorstehend beschriebenen Herstellungsverfahrens ist demnach ein Nanodraht-Strukturelement mit einer Hohlraumstruktur, welche aus einem Array aus einer Vielzahl von nebeneinander angeordneten Nanodrähten und zwei parallel beabstandeten, flächig geschlossenen Deckschichten besteht, nachdem die Templatfolie entfernt wurde. Die beiden Deckschichten sind integraler Bestandteil des Nanodraht-Strukturelements und werden nicht von den Nanodrähten getrennt, sondern bleiben fest mit diesen verbunden, genauer sind durch den elektrochemischen Abscheidevorgang auf atomarer/molekularer Ebene miteinander verwachsen.

Demnach erstrecken sich die Nanodrähte quer zwischen den beiden Deckschichten und die Nanodrähte sind mit ihrem ersten Ende mit der ersten Deckschicht und mit ihrem zweiten Ende mit der zweiten Deckschicht verwachsen, so dass die Nanodrähte die beiden Deckschichten fest miteinander verbinden und wie ein Säulenarray den Abstand zwischen den beiden Deckschichten definieren. Dadurch entsteht eine stabile sandwichartige Nanostruktur mit einer zweiseitig von den Deckschichten begrenzten und von der Vielzahl von Nanodrähten säulenartig durchsetzten Hohlraumstruktur.

Ferner sind die Nanodrähte selbst voneinander beabstandet, so dass sich zwischen den Nanodrähten Zwischenräume befinden, welche miteinander verbunden sind. Die Hohlraumstruktur ist demnach in der Ebene parallel zu den Deckschichten zweidimensional offenzellig, so dass zwischen den beiden Deckschichten ein Fluid durch die zweidimensional offenzellige Hohlraumstruktur geleitet werden kann, um mit den Zylinderflächen der Nanodrähte, welche eine große Oberfläche bilden, in Wechselwirkung zu treten.

Durch das Herstellungsverfahren ergeben sich aber noch weitere bestimmte strukturelle Eigenschaften des erzeugten Nanodraht-Strukturelements. Dadurch dass die Nanodrähte aus elektrochemisch abgeschiedenem Material gewachsen sind, können sie eine spezifische Kristallstruktur haben, die z.B. mittels Röntgendiffraktion untersucht werden kann. Ferner sind die Nanodrähte aufgrund der elektrochemischen Abscheidung beidseitig mit der jeweiligen Deckschicht unmittelbar fest verwachsen. Dadurch dass die elektrochemische Abscheidung der Nanodrähte zumindest solange fortgeführt wird, bis die Kappen gewachsen und ggf. zusammengewachsen sind, sind die Nanodrähte und zumindest ein Teil der zweiten Deckschicht einstückig gewachsen. Auch dies läßt sich strukturell nachweisen, insbesondere wenn die Nanodrähte einstückig mit den Kappen gewachsen und diese zumindest teilweise miteinander verwachsen sind. Wenn der Abscheidevorgang mit dem die Nanodrähte erzeugt wurden, nach dem Zusammenwachsen der Kappen beendet wird und damit eine erste Teilschicht der zweiten Deckschicht bildet und eine zweite Teilschicht auf den miteinander verwachsenen Kappen in einem separaten Schritt mit geänderten Verfahrensparametern abgeschieden wird, kann auch dies strukturell nachweisbar sein. Dies gilt nicht nur, wenn die Deckschicht zwei Teilschichten aus unterschiedlichem Material umfasst.

Der Durchmesser der Nanodrähte ist kleiner oder gleich 2000 nm, besonders bevorzugt kleiner oder gleich 500 nm bzw. kleiner oder gleich 100 nm. Derzeit erscheinen Durchmesser bis hinunter zu 10 nm oder sogar noch kleiner herstellbar zu sein.

Je größer das Aspektverhältnis ist, desto größer läßt sich die aktive Oberfläche des Nanodraht-Strukturelements erzeugen. Das Aspektverhältnis der Nanodrähte ist daher vorzugsweise größer oder gleich 1 zu 50, besonders bevorzugt größer oder gleich 1 zu 100.

Der Abstand der beiden Deckschichten voneinander bzw. die Länge der Nanodrähte wird durch die Dicke der Templatfolie definiert und ist vorzugsweise kleiner oder gleich 200 $\mu$m, besonders bevorzugt kleiner oder gleich 50 $\mu$m.

Die Flächendichte der Anzahl der Nanodrähte ist ebenfalls ein Maß für die aktive Oberfläche und ist vorzugsweise größer oder gleich $n/F = 10^7$ cm$^{-2}$, besonders bevorzugt größer oder gleich $n/F = 10^8$ cm$^{-2}$.

Als spezifisches Maß für die aktive Oberfläche des Nanodraht-Strukturelements, kann die geometrische spezifische Oberfläche der Nanodrähte pro Fläche des Nanostrukturelements (Fläche der Deckschichten) und pro Länge der Nanodrähte (Höhe des strukturierten Hohlraums) dienen. Diese geometrische spezifische Oberfläche $A_V$ ist demnach

$$A_V = \pi D \cdot \frac{n}{F} \, ,$$

wobei D der mittlere Durchmesser der Nanodrähte und n/F die Flächendichte der Nanodrähte ist.

Die geometrische spezifische Oberfläche $A_V$ sollte mindestens 1 mm$^2$/(cm$^2$ $\mu$m) betragen; bevorzugt sind jedoch größere Werte, nämlich $A_V$ größer oder gleich 5 mm$^2$/(cm$^2$ $\mu$m), größer oder gleich 20 mm$^2$/(cm$^2$ $\mu$m) oder sogar größer oder gleich 100 mm$^2$/(cm$^2$ $\mu$m). Ggf. können sogar Werte bis 1000 mm$^2$/(cm$^2$ $\mu$m) erreicht werden.

Bei Herstellung der Nanodrähte mit dem Umkehrpulsverfahren besitzen die Nanodrähte eine deutliche <100>-Textur, bzw. eine kristallitische Struktur. Für bestimmte Metalle, wie z.B. Gold kann es vorteilhaft sein, möglichst kleine Kristallite zu erzeugen. Hierfür wird bevorzugt, eine Kristallitgröße von kleiner oder gleich 4 nm zu erzielen, wobei allgemein bereits eine mittlere Kristallitgröße von kleiner oder gleich 10 nm von Vorteil sein kann.

Durch die kristallitische Textur ist die tatsächliche Größe der Oberfläche größer als die geometrische spezifische Oberfläche $A_V$, die auf der glatten Zylinderoberfläche basiert, und zwar vorliegend vorzugsweise etwa um einen Faktor 4 bis 5.

Gemäß einer besonderen Ausführungsform der Erfindung können auch sehr kleine Nanodraht-Strukturelemente hergestellt werden. Hierzu wird die Templatfolie durch eine Maske mit einer oder mehreren Öffnungen bestrahlt, so dass die latenten Spuren nur im Bereich der Öffnungen der Maske erzeugt werden. Es entstehen also Inseln mit latenten Spuren. Nach dem Ätzen und Aufbringen einer ersten Kathodenschicht auf der ersten Seite der Templatfolie werden die Nanodrähte in den Nanoporen und die Kappen auf der zweiten Seite der Templatfolie solange abgeschieden, bis die Kappen auf der zweiten Seite der Templatfolie inselweise zusammengewachsen sind. Anschließend wird auf die inselweise zusammengewachsenen Kappen Insel-übergreifend eine elektrisch leitfähige Schicht abgeschieden, die die Inseln miteinander verbindet. Diese Schicht dient später als zweite Kathodenschicht. Nachdem diese zweite Kathodenschicht erzeugt wurde, wird die erste Kathodenschicht wieder entfernt und die elektrochemische Abscheidung in umgekehrter Richtung fortgesetzt, wobei nun auf der ersten Seite der Templatfolie Kappen auf den Nanodrähten aufwachsen. Dieser Abscheidevorgang wird ebenfalls solange fortgeführt bis die Kappen inselweise zusammengewachsen sind. Nachfolgend wird die zweite Kathodenschicht wieder entfernt und die Templatfolie aufgelöst. Es entsteht eine Vielzahl von inselartigen Nanodraht-Strukturelementen mit beidseitigen Deckschichten jeweils aus zusammengewachsenen Kappen. Diese inselartigen Nanodraht-Strukturelemente sind sehr klein, z.B. mit einem Durchmesser einiger bis einiger 10 Mikrometer, ggf. einiger 100 Mikrometer und werden daher hier als Mikroelemente bezeichnet.

Es ist sogar möglich, komplexe Bauelemente mit mehreren inselartigen Mikroelemente zu designen. Hierzu wird die zweite Kathodenschicht nicht entfernt oder es werden eine oder mehrere neue Deckschichten aufgebracht, bevor die Templatfolie aufgelöst wird. Die neu aufgebrachte(n) Deckschicht(en) kann/können elektrisch leitfähig, oder sogar elektrisch isolierend sein. Größe und Verteilung der Inseln werden durch die Öffnungen in der Bestrahlungsmaske vordefiniert. Es kann demnach ein Bauelement hergestellt werden, welches eine Mehrzahl von vordefiniert angeordneten inselartig auf einer Substratschicht verteilten Mikroelementen umfasst, wobei die inselartigen Mikroelemente in einem durch die Bestrahlungsmaske vordefinierten Muster auf der Substratschicht verteilt sind und fest mit der Substratschicht verbunden sind. Die Substratschicht kann insbesondere elektrisch leitfähig oder elektrisch isolierend sein, so dass die Mikroelemente untereinander elektrisch verbunden oder isoliert sind.

Ein besonders bevorzugtes Anwendungsfeld für die erfindungsgemäß hergestellten Nanodraht-Strukturelemente ist die heterogene Katalyse. D.h. ein oder mehrere Nanodraht-Strukturelemente dienen als Katalysator-Bauelemente, insbesondere für Mikrokatalysatoren. Hierzu ist es vorteilhaft an einer oder mehreren Seiten eine Deckschicht um die Stirnseite herum zu ziehen und mit der anderen Deckschicht verwachsen zu lassen, d.h. die jeweilige Stirnseite integral an dem Nanodraht-Strukturelement zu verschließen. Besonders einfach ist es, zunächst alle Stirnseiten zu verschließen und anschließend das Nanodraht-Strukturelement an z.B. zwei gegenüberliegenden Stirnseiten quer zur Ebene der Deckschichten abzuschneiden.

Ein Mikrokatalysator umfasst vorzugsweise ein mikrostrukturiertes Kanalsystem mit einer Fluidzuführung und einer Fluidabführung und zumindest ein Nanodraht-Strukturelement als Katalysatorelement zwischen der Fluidzuführung und der Fluidabführung, so dass Fluid aus der Fluidzuführung in die Hohlraumstruktur zwischen den beiden Deckschichten eingeleitet, durch die Zwischenräume zwischen den Nanodrähten hindurch geleitet und durch die Fluidabführung wieder aus der Hohlraumstruktur abgeführt werden kann. Hierbei bildet die zweidimensional offenzellige Hohlraumstruktur des Nanodraht-Strukturelements zwischen den beiden Deckschichten das katalytische Reaktionsvolumen und die Zylinderflächen der Nanodrähte bilden die katalytisch aktive Oberfläche mit der das Fluid innerhalb der Hohlraumstruktur wechselwirkt. Vorzugsweise sind die Nanodrähte aufgrund der Abscheidung massiv ausgebildet, z.B. aus Platin, so dass das Katalysatorelement ein Vollkatalysatorelement ist.

Im Folgenden wird die Erfindung anhand von Ausführungsbeispielen und unter Bezugnahme auf die Figuren näher erläutert, wobei gleiche und ähnliche Elemente teilweise mit gleichen Bezugszeichen versehen sind und die Merkmale der verschiedenen Ausführungsbeispiele, insbesondere die Verfahren mit und ohne Bestrahlungsmaske, miteinander kombiniert werden können.

## Kurzbeschreibung der Figuren

Es zeigen:

Fig. 1     eine Übersicht über die Herstellung eines Nanodraht-Strukturelements: (c1) Beschuss mit Ionen, (b) Aufbringen einer leitfähigen Schicht, (c2) Ätzen der Ionenspuren, (d1) Abscheidung der Nanodrähte und Kappenwachstum, (d2) Abscheiden einer zweiten Metallschicht, (e) Auflösen des Templats,

Fig. 2     eine dreidimensionale schematische Darstellung des erfindungsgemäßen Nanodraht-Strukturelements,

Fig. 3     eine dreidimensionale Darstellung der zur elektrochemischen Abscheidung verwendeten Abscheidevorrichtung,

Fig. 4     eine dreidimensionale transparente Explosionsdarstellung der Abscheidevorrichtung für die Abscheidung der ersten Deckschicht,

Fig. 5     eine dreidimensionale transparente Explosionsdarstellung der Abscheidevorrichtung für die Abscheidung der Nanodrähte und der zweiten Deckschicht,

Fig. 6     eine Rasterelektronenmikroskop-Aufnahme (REM) eines erfindungsgemäßen Nanodraht-Strukturelements,

Fig. 7     eine vergrößerte Seitenansicht des Nanodraht-Strukturelements aus Fig. 6,

Fig. 8     eine REM-Aufnahme eines stirnseitig zweiseitig geöffneten und stirnseitig zweiseitig geschlossen Nanodraht-Strukturelements mit einem Nanodraht-Array aus Platin-Nanodrähten,

Fig. 9     eine vergrößerte REM-Aufnahme des Nanodraht-Arrays aus Fig. 8,

Fig. 10     eine REM-Aufnahme (Kantenlänge ca. 350 $\mu$m) eines unter Gleichstrom abgeschiedenen Platin-Nanodraht-Arrays mit Kappen unterschiedlicher Größe,

Fig. 11     einen vergrößerten Ausschnitt aus Fig. 10 (Kantenlänge ca. 100 $\mu$m),

Fig. 12     eine REM-Aufnahme eines unter Gleichstrom abgeschiedenen Pt-Nanodraht-Arrays, die die räumliche Verteilung der Kappen wiedergibt und die das lokal begrenzte Wachstum von Kappen zeigt,

Fig. 13     eine Ausschnittsvergrößerung der Aufnahme aus Fig. 12,

Fig. 14     eine REM-Aufnahme eines unter Umkehrpulsen abgeschiedenen Pt-Nanodraht-Arrays mit zu einer dichten Schicht zusammengewachsenen Kappen,

Fig. 15 einen vergrößerten Ausschnitt aus Fig. 14,

Fig. 16 eine REM-Aufnahme eines Pt-Nanodraht-Arrays, das mechanischer Belastung ausgesetzt wurde,

Fig. 17 eine Ausschnittvergrößerung aus Fig. 16,

Fig. 18 eine schematische Explosionsdarstellung eines Mikroreaktors mit dem Nanodraht-Strukturelement für den Durchflussbetrieb,

Fig. 19 eine Ausschnittsvergrößerung einer Lochmaske,

Fig. 20 eine Ausschnittsvergrößerung einer Öffnung der Lochmaske aus Fig. 19,

Fig. 21 eine Übersicht über die Herstellung einer Vielzahl von inselartigen Mikroelement-Nanodraht-Strukturelementen mit einer Lochmaske,

Fig. 22 eine REM-Aufnahme eines Mikroelement-Nanodraht-Strukturelements mit Blick auf eine der beiden Deckschichten,

Fig. 23 eine weitere REM-Aufnahme des Mikroelement-Nanodraht-Strukturelements aus Fig. 22 mit Blick schräg auf den Umfang des Mikroelement-Nanodraht-Strukturelements und

Fig. 24 eine schematische Darstellung eines Sensorelements mit zwei Mikroelement-Nanodraht-Strukturelementen.

### Detaillierte Beschreibung der Erfindung

### Übersicht über das Herstellungsverfahren

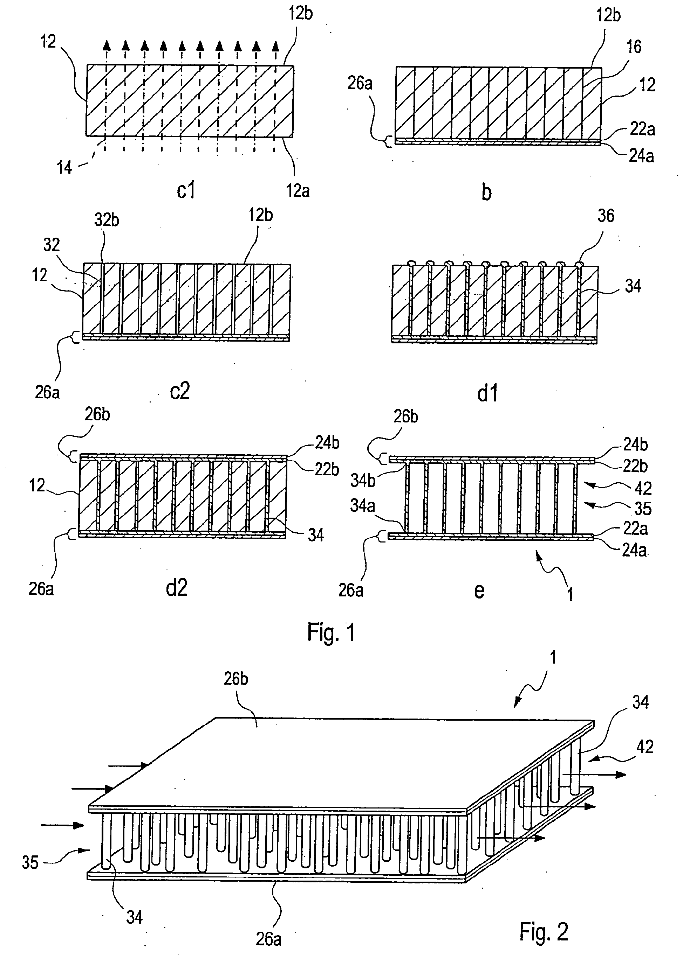

Die Herstellung des Nanodraht-Strukturelements basiert auf einem templatbasierten Verfahren. Die Teilschritte des Verfahrens sind in Fig. 1 schematisch dargestellt. Der Übersichtlichkeit halber korrespondieren die Buchstaben dabei mit den vorstehend genannten Verfahrensschritten, welche vorzugsweise in der in Fig. 1 dargestellten Reihenfolge, d.h. (cl), (b), (c2), (d1), (d2), (e) durchgeführt werden. Es ist aber grundsätzlich auch möglich eine andere Reihenfolge zu verwenden, z.B. von zwei Seiten zu ätzen und anschließend erst die Kathodenschicht aufzubringen Teilschritt ((c2) vor Schritt (b)).

Bezug nehmend auf Fig. 1 wird zunächst eine Templatfolie 12 mit Ionen 14 beschossen, wobei entlang der Trajektorien latente Ionenspuren 16 im Material der Templatfolie 12 erzeugt werden (c1). Die Templatfolie 12 ist in diesem Beispiel eine Polymerfolie, genauer eine Polycarbonatfolie.

Nachfolgend wird auf der ersten Seite 12a der Templatfolie 12 eine dünne, leitende Metallschicht 22a, z. B. Gold aufgesputtert, welche eine erste Teilschicht bildet.

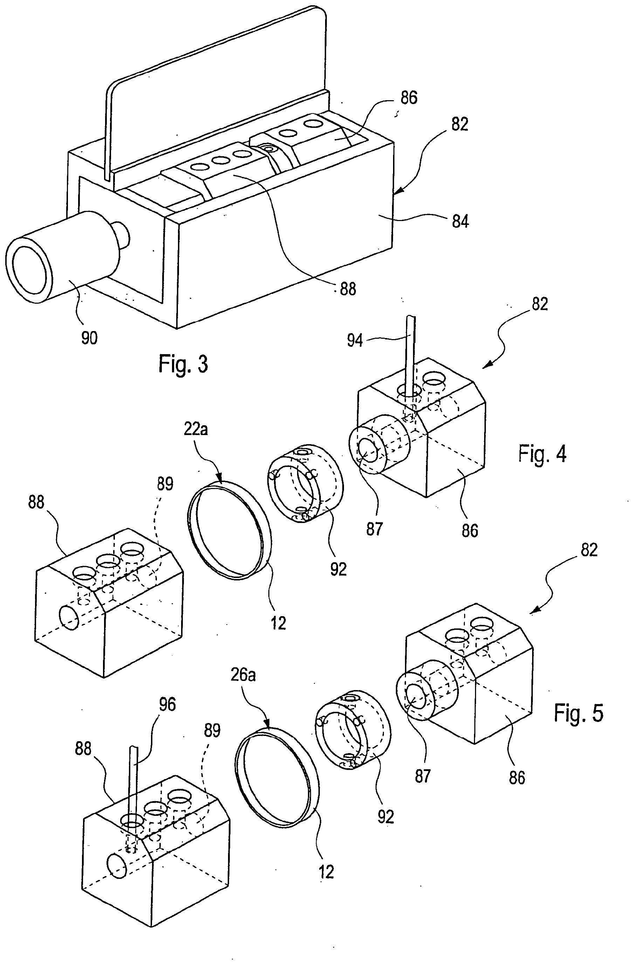

Anschließend wird die erste Teilschicht 22a mit einer zweiten Teilschicht 24a elektrochemisch verstärkt, so dass die erste Deckschicht 26a gebildet wird, die später als Kathode zur Nanodrahtabscheidung dient (b). Zur elektrochemischen Abscheidung der zweiten Teilschicht 24a wird die Templatfolie 12 in die in Fig. 3-5 gezeigte Abscheidevorrichtung 82 eingespannt.

Anschließend wird die einseitig beschichtete Templatfolie 12 wieder aus der Abscheidevorrichtung 82 entfernt, und die latenten Ionenspuren 16 werden chemisch geätzt, wodurch einheitliche Nanoporen 32 erzeugt werden. Alternativ kann der Ätzprozess auch in der Abscheidevorrichtung 82 erfolgen, indem die Ätzlösung in die entsprechende Zelle 88 eingefüllt und nach Abschluss der Ätzung wieder entfernt wird. Eine Entfernung der Templatfolie und der erneute Einbau sind nicht erforderlich. Der Durchmesser der Nanoporen 32 kann mittels Steuerung der Ätzzeit kontrolliert werden (c2).

Nachfolgend wird die so vorbereitete Templatfolie 12 wieder in die Abscheidevorrichtung 82 eingespannt und in einem zweiten elektrochemischen Prozess wird das gewünschte Metall in die Nanoporen 32 abgeschieden (d1). Erreichen die Nanodrähte 34 das Porenende 32b an der zweiten Seite 12b der Templatfolie 12, so beginnen sich Kappen 36 auszubilden. Unter geeigneten Bedingungen wachsen die Kappen 36 flächig zusammen und bilden eine zweite geschlossene, aber noch nicht hinreichend stabile Metallschicht 22b parallel zur ersten Deckschicht oder Kathodenschicht (d2). Diese Metallschicht ist bei diesem Beispiel eine erste Teilschicht 22b, auf die eine weitere Metallschicht abgeschieden wird, welche eine zweite Teilschicht 24b bildet (d2). Mittels der zweiten Teilschicht 24b werden die zusammengewachsenen Kappen mechanisch stabil eingebettet. Somit bilden die erste und zweite Teilschicht 22b, 24b gemeinsam die zweite Deckschicht 26b.

Schließlich wird die Polymerfolie 12 in einem geeigneten organischen Lösungsmittel aufgelöst (e). Das hiermit erfindungsgemäß hergestellte Nanodraht-Strukturelement 1 ist in Fig. 2 dargestellt. Zumindest die der Hohlraumstruktur 42 zugewandte Innenseite der zweiten Deckschicht 26b wird hierin zumindest teilweise durch eine elektrochemisch abgeschiedene Schicht 22b gebildet.

Die templatbasierte Methode bietet den Vorteil, dass viele Parameter gezielt beeinflusst werden können. Die Länge der Nanodrähte 34 wird durch die Dicke des verwendeten Templats 12 bestimmt und beträgt vorzugsweise 10 bis 100 $\mu$m, besonders bevorzugt etwa 30 $\mu$m $\pm$ 50%. Die Flächendichte der Nanodrähte 34 wird durch die Bestrahlung festgelegt und liegt für die Herstellung der Arrays bevorzugt zwischen $1\cdot10^7$ bis $1\cdot10^9$ cm$^{-2}$. Der Durchmesser D der Nanodrähte 34 wird durch die Dauer der Ätzung eingestellt und kann von ca. 20 nm bis 2000 nm reichen. Das Aspektverhältnis kann Werte von bis zu 1000 annehmen.

Die Dicke der beiden Deckschichten 26a, 26b wird durch die Dauer der jeweiligen elektrochemischen Abscheidung kontrolliert und sollte so dick sein, dass eine ausreichende Stabilität gewährleistet ist. Vorzugsweise beträgt sie jeweils ca. 5 $\mu$m bis 10 $\mu$m.

Als Materialien für die Nanodrähte kommen Metalle, die sich zur elektrochemischen Abscheidung eignen, in Frage. Erfahrung wurde mit folgenden Metallen gesammelt: Cu, Au, Bi, Pt, Ag, Cu, Cu/Co Multilayer, $Bi_2Te_3$.

Einerseits ist eine hohe Anzahl an Nanodrähten 34 mit geringem Durchmesser D wünschenswert, um ein große aktive Oberfläche zu erhalten, andererseits soll eine gute mechanische Stabilität erzielt werden. Diese Optimierung ist vom Material abhängig und wird den Erfordernissen angepasst.

Für Nanodraht-Strukturelemente 1 mit Platin-Nanodrähten 34 zwischen Kupferteilschichten 24a, 24b wurde z. B. eine stabile Ausführung mit $10^8$ Drähten pro $cm^2$, die einen Durchmesser von 250 nm und eine Länge von 30 μm besitzen, hergestellt. Das Aspektverhältnis betrug hier 120. Solche Elemente eignen sich z.B. als Katalysatorelemente.

Zur Herstellung der Nanodraht-Strukturelemente 1 können alternativ zu Polymerfolien 12 auch andere Templatfolien wie harte Templatfolien aus Aluminiumoxid eingesetzt werden. Die erreichbaren Porendurchmesser liegen hier zwischen 10 und 200 nm. Die Dichte reicht hier von ca. $6,5 \cdot 10^8$ bis $1,3 \cdot 10^{11}$ $cm^{-2}$. Poröse Aluminiumoxid-Template ermöglichen die Erzeugung von regelmäßig geordneten Strukturen. Vorstellbar als Templat sind auch ionenspurgeätzte Gläser und Glimmer-Filme. Bei diesen Templaten erfolgt die Auflösung des Templats mit Flusssäure (HF), wodurch die Auswahl an Metallen für die Drahtabscheidung und die Metallschichten etwas eingeschränkt ist.

Beispiel 1

Zur Herstellung eines Nanodraht-Strukturelements 1 wird eine 30 μm dicke, kreisförmige (r=1,5 cm) Polycarbonatfolie 12 (Makrofol®), die mit schweren Ionen 14 mit einer Energie von 11,1 MeV/u und einer Fluenz von $3 \cdot 10^7$ Ionen/$cm^{-2}$ bestrahlt wurde, verwendet. Vor dem Aufbringen der leitenden Metallschicht 22a wird jede Seite der Polymerfolie 12 für eine Stunde mit UV-Licht bestrahlt, um die Selektivität der Ätzung entlang der Spuren 16 zu erhöhen.

Auf die erste Seite 12a der Polymerfolie 12 wird eine ca. 30 nm dicke Goldschicht 22a aufgesputtert. Diese wird verstärkt, indem Kupfer aus einer auf $CuSO_4$ basierenden Elektrolytlösung (Cupatierbad, Riedel) potentiostatisch bei einer Spannung von U = -500 mV abgeschieden wird, wobei eine Kupferstabelektrode als Anode dient (Teilschicht 24a). Die Abscheidung wird nach 30 min abgebrochen, wonach die Kupferschicht 24a ungefähr 10 μm dick ist. Im Anschluss wird bei 60 °C mit NaOH-Lösung (6 M) für 25 min von der unbehandelten Seite 12b der Templatfolie 12 geätzt und mit entionisiertem Wasser gründlich gespült, um Reste der Ätzlösung zu entfernen. Nun wird die nanoporierte Templatfolie 12 in die Abscheidevorrichtung 82 eingespannt.

Die Abscheidung der Nanodrähte 34 erfolgt bei 65 °C mit einem alkalischen Pt-Elektrolyten (Pt-OH-Bad, Metakem). Zur Erzeugung der Nanodrähte 34 und der Kappen 36 wird das Verfahren der Umkehrpulsabscheidung angewendet, um den langsamen diffusionsgetriebenen Massentransport in den Nanoporen 32 zu kompensieren und einheitliches Nanodraht- und Kappenwachstum 34, 36 zu erzielen. Auf einen Abscheidungspuls mit U = -1,3 V für 4 s folgt ein anodischer Puls für 1 s bei U = +0,4 V. Nach ca. 80 min wird die Abscheidung gestoppt und das Wachstum kontrolliert. Die Kappen 36 sind zu diesem Zeitpunkt ausreichend zu einer Teilschicht 22b zusammengewachsen, so dass darauf die potentiostatische Abscheidung einer Kupfer-Teilschicht 24b bei U = -500 mV für ca. 30 min erfolgen kann.

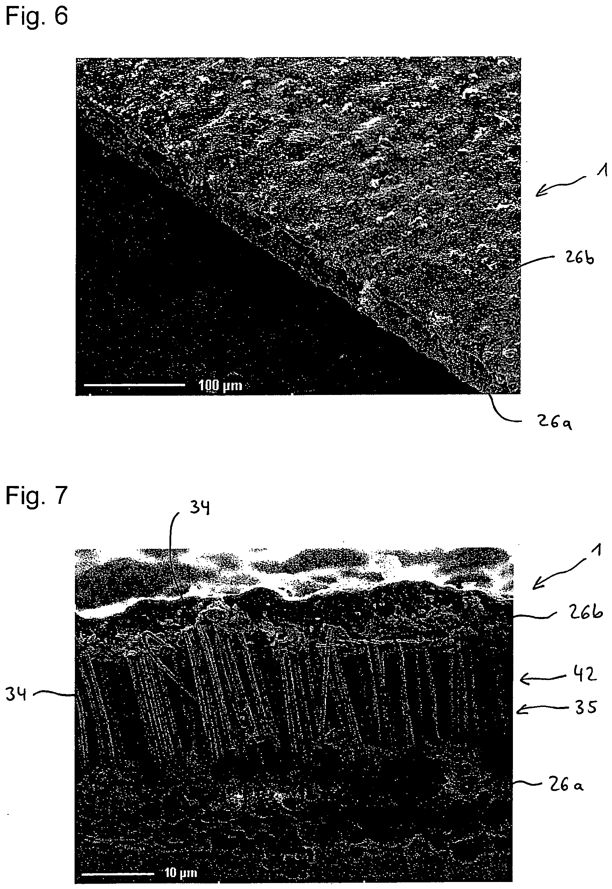

Schließlich wird das Templatmaterial entfernt, indem das ganze Nanodraht-Strukturelement mit der Templatfolie 12 für mehrere Stunden in ein Gefäß mit 10 ml Dichlormethan gelegt wird. Das Lösungsmittel wird dreimal gewechselt, um Polymerreste aus dem Innenraum 38 der beidseits durch die Deckschichten geschlossenen Struktur vollständig zu entfernen. Die auf diese Weise hergestellte Hohlraumstruktur 42 zwischen den Deckschichten 26a, 26b mit dem Nanodraht-Array 35 ist in Raster-Elektronenmikroskopaufnahmen (REM) in den Fig. 6 und 7 zu sehen. Die Nanodrähte 34 haben hier einen Durchmesser von ungefähr 650 nm.

Beispiel 2

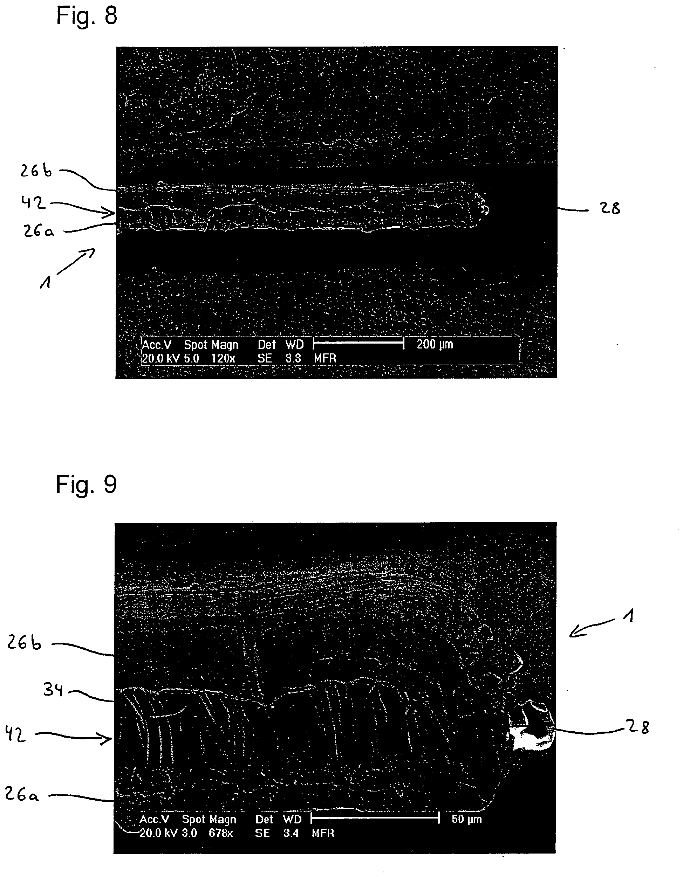

Bezug nehmend auf die Fig. 8 und 9 wurde ein weiteres Ausführungsbeispiel hergestellt, u. a. um zu zeigen, dass die Parameter Durchmesser und Anzahl der Nanodrähte 31 variiert werden können. Die Ätzzeit von 18 min ergibt Nanodrähte 34, die einen Durchmesser von ca. 250 nm besitzen. Die Flächendichte (Anzahl pro Fläche) beträgt $10^8$ $cm^{-2}$. Zur elektrochemischen Abscheidung der Drähte wurde erneut die Umkehrpulsmethode verwendet. Auf einen Abscheidungspuls von $U_1$ = -1,4 V für 40 ms folgte ein kurzer Gegenpuls mit $U_2$ = -0,1 V für 2 ms und eine Pulspause von 100 ms bei einer Spannung von U = -0,4 V, was einer Überspannung von ca. 0 V entspricht. D. h. während des Gegenpulses befindet sich das System im Gleichgewichtszustand.

Das Nanodraht-Array 35 wurde zu einem im Grundriss rechteckigen Nanodraht-Strukturelement 1 geschnitten. Anschließend wurde erneut eine Kupferschicht potentiostatisch auf das gesamte Nanodraht-Strukturelement noch mit Templatfolie 12 abgeschieden, so dass es auch an allen Stirnseiten geschlossen ist. Anschließend wurde es an den beiden kurzen Stirnseiten oder Kanten abgeschnitten und nachfolgend das Templat 12 aufgelöst, um ein an zwei gegenüberliegenden Stirnseiten geöffnetes und ein an den zwei übrigen gegenüberliegenden Stirnseiten geschlossenes Nanodraht-Strukturelement 1 zu erhalten. Es ist gut zu erkennen, dass die in den Fig. 8 und 9 rechts gezeigte Stirnseite 28 fluiddicht geschlossen ist, indem die obere Deckschicht 26b um die Stirnseite 28 herumgezogen ist. Dieses Nanodraht-Strukturelement 1 eignet sich hervorragend als Katalysatorelement zum Durchleiten eines zu katalysierenden Fluids, welches an der einen offenen Stirnseite eingeleitet wird und an der gegenüberliegenden offenen Stirnseite wieder ausfließen kann.

Aufbau für die elektrochemische Abscheidung

Wieder Bezug nehmend auf die Fig. 3-5 erfolgt die elektrochemische Abscheidung des aus einer Vielzahl von Nanodrähten 34 bestehenden Nanodraht-Arrays 35 vollständig in der in Fig. 3 gezeigten Abscheidevorrichtung 82. Sie besteht aus einem Metallgehäuse 84, in das ein die beiden Elektrolysezellen 86, 88 fassender Metallschlitten geschoben werden kann. Aufgrund der guten Wärmeleitfähigkeit von Metall ist es möglich, die Abscheidevorrichtung durch kontrollierte externe Wärmezufuhr zu temperieren.

Die aus PCTFE gefertigten Elektrolysezellen 86, 88 besitzen auf den einander zugewandten Seiten jeweils eine gleich große kreisförmige Öffnung 87, 89 und können durch eine Handschraube 90 dicht aufeinander gepresst werden. Ein Kupferring 92 zwischen den beiden Elektrolysezellen 86, 88 dient als Kathode bzw. zum Kontaktieren der ersten Deckschicht für die elektrochemische Abscheidung.

Bezug nehmend auf Fig. 4 wird zur elektrochemischen Verstärkung der Teilschicht 22a die ionenspurgeätzte Templatfolie 12 so zwischen die beiden Elektrolysezellen 86, 88 montiert, dass die Teilschicht 22a, hier die aufgesputterte Goldschicht 22a, guten Kontakt mit der ringförmigen Kupferelektrode 92 hat. Auf beiden Seiten des als Kathode verwendeten Kupferringes werden Elektrolyte in die Elektrolysezellen gefüllt. Mit einer ersten Anode 94, welche in der der Teilschicht 22a zugewandten Elektrolysezelle 86 angeordnet ist, und externer Stromversorgung mit Steuergerät erfolgt die elektrochemische Verstärkung der Goldschicht 22a zur ersten Deckschicht 26a.

Nach Entnahme der Templatfolie 12 und Ätzung der Nanoporen 32 außerhalb der Abscheidevorrichtung 82 wird die Templatfolie 12 wieder in die Abscheidevorrichtung 82 eingesetzt.

Bezug nehmend auf Fig. 5 wird zur elektrochemischen Abscheidung der Nanodrähte 34, der Kappen 36 und ggf. der vollständigen zweiten Deckschicht 26b die einseitig beschichtete und mit Nanoporen versehene Templatfolie 12 wie in Fig. 4 wieder in die Abscheidevorrichtung 82 eingespannt, so dass die erste Deckschicht 26a Kontakt zu der Ringelektrode 92 hat. Nun wird auf der zweiten Seite 12b der Templatfolie 12 in der der ersten Deckschicht 26a abgewandten Elektrolysezelle 88 mit einer hierin angeordneten zweiten Anode 96 abgeschieden.

Untersuchung des Einflusses der elektrochemischen Abscheidebedingungen auf das Nanodraht- und Kappenwachstum

Mit dem gepulsten Abscheideverfahren zur Erzeugung der Nanodrähte 34 kann vorteilhafterweise eine einheitliche Länge der Nanodrähte zu jedem Zeitpunkt der Abscheidung erreicht werden. Dies kann ohne Anspruch auf Vollständigkeit und Richtigkeit dadurch erklärt werden, dass die Diffusionsschichten im Vergleich zur Gleichstromabscheidung kurz gehalten werden. In den Pausen (Gleichgewichtszustand oder Gegenpuls) zwischen den Abscheidungspulsen können Metallionen nachdiffundieren, sodass auf der gesamten Elektrodenoberfläche nahezu gleiche Konzentrationsverhältnisse zu Beginn eines jeden Abscheidungspulses vorliegen, was zu homogenem Wachstum führt. Die Diffusionsschichten überschneiden sich kaum und Unregelmäßigkeiten in der Oberfläche werden nicht verstärkt.

Es wurde nun festgestellt, dass das gepulste Abscheideverfahren außerdem eine enge Größenverteilung der Kappen 36 gewährleistet und es daher vorteilhaft ist, das gepulste Abscheideverfahren zumindest noch für die Herstellung der Kappen einzusetzen.

Um das Kappenwachstum zu untersuchen wurden Versuche unter Gleichstromabscheidung und unter Umkehrpulsabscheidung durchgeführt und verglichen.

Abscheidung unter Gleichstrom

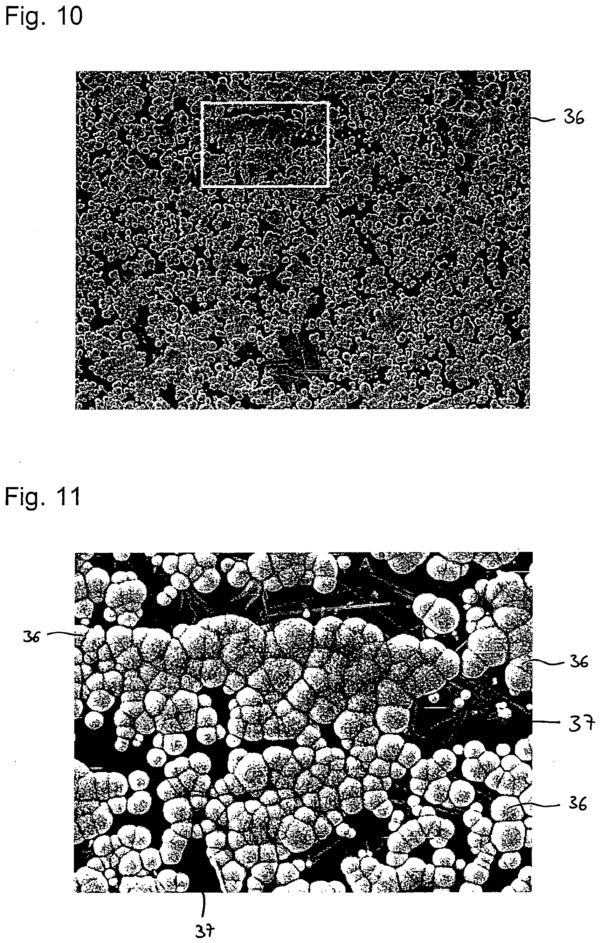

Die Fig. 10 und 11 zeigen ein unter Gleichstrom gebildetes Nanodraht-Array nach der Ausbildung der Kappen 36. D.h. das Herstellungsverfahren wurde nach der Ausbildung der Kappen 36 abgebrochen und die Templatfolie 12 wurde ohne Erzeugung der vollständigen zweiten Deckschicht 26b entfernt, um das Kappenwachstum genauer zu untersuchen. Ist die Vergrößerung nicht zu groß, so erscheinen die Kappen 36 in ihrer Größenverteilung einigermaßen homogen (Fig. 10). Klar zu erkennen ist aber, dass die Kappen 36 zwar teilweise zusammengewachsen sind, sich aber noch ausgedehnte Lücken 37 zwischen ihnen auftun. Darüber hinaus sind einige isolierte Kappen 36 auszumachen.

Deutlicher wird dies in der Vergrößerung in Fig. 11, in der zusätzlich ein Eindruck der Größenverteilung vermittelt wird. Die Kappen zeigen sowohl eine starke Abweichung in ihrer räumlichen Ausdehnung, als auch in ihrer Konnektivität zu anderen Kappen 36.

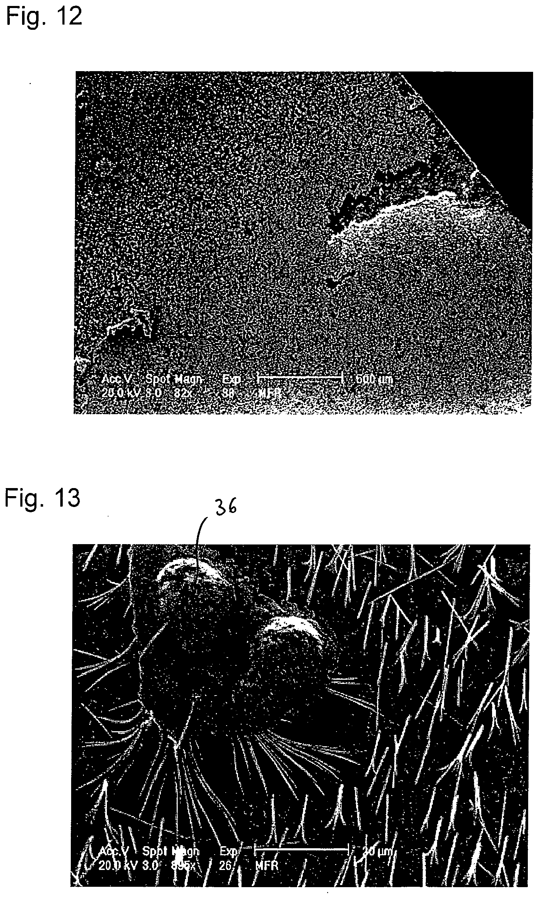

Fig. 12 zeigt eine größere Fläche eines Nanodraht-Arrays, das unter Gleichstrom hergestellt wurde, ebenfalls zu Untersuchungszwecken nach Entfernung der Templatfolie 12 ohne Erzeugung der vollständigen zweiten Deckschicht 26b. Es ist zu erkennen, dass das Wachstum der Kappen 36 von der Position auf dem Array abhängig ist.

Bezug nehmend auf die vergrößerte Darstellung in Fig. 13 ist die räumliche Verteilung der Kappen 36 nicht homogen. Insbesondere sind einzelne isolierte Kappen 36, umgeben von zahlreichen Drähten, die Kappenwachstum nicht einmal ansatzweise zeigen, zu sehen.

Ohne Anspruch auf Vollständigkeit und Richtigkeit wird als Hauptursache für die Verbreiterung der Größenverteilung die Überschneidung der Diffusionschichten einzelner Nanoelektroden angesehen, als welche die Nanodrähte behandelt werden können. Befinden sich die Nanodrähte 34 noch tief in den Nanoporen 32, müssen die Metallionen einen langen Weg durch planare Diffusion zurücklegen. Je länger die Nanodrähte 34 wachsen, desto höher steigen sie in den Poren 32 und nähern sich dem Porenende 32b, wo das Kappenwachstum 36 beginnt, an. Damit verbunden reicht die Diffusionsschicht weiter in die Lösung hinein und die Wahrscheinlichkeit einer Überschneidung mit anderen Schichten steigt. Zusätzlich ist zu berücksichtigen, dass die Diffusion mit fortschreitendem Wachstum vom planaren Verhalten abweicht und schließlich als vollständig hemisphärisch angesehen werden kann, sobald die Länge der Nanodrähte 34 mit der Dicke der Polymerfolie 12 übereinstimmt.

Nanoelektroden, die sich in geringer Entfernung zu anderen befinden, konkurrieren um Metallionen aus der Lösung und unterliegen infolgedessen einem langsameren Wachstum als Elektroden, die sich in relativer Isolation befinden. Die Verbreiterung der Größenverteilung ist demnach eine direkte Konsequenz der Zufälligkeit, mit der die Poren 32 angeordnet sind.

Vermutlich nehmen die Unterschiede in den Wachstumsgeschwindigkeiten extreme Werte an, sobald planare und hemisphärische Diffusion nebeneinander vorliegen. Dies ist dann der Fall, wenn ein Nanodraht 34 das Porenende 32b erreicht und beginnt, eine Kappe 36 auszubilden, während sich die Drähte 34 in der unmittelbaren Umgebung noch in den Poren 32 befinden, wo sie planaren Diffusionsprozessen unterworfen sind. Aufgrund der naturgemäß rauhen Oberfläche der Polymerfolie 12 besitzen die Poren 32 von Beginn an unterschiedliche Länge, wodurch die Nanodrähte 34 bei gleicher Wachstumsgeschwindigkeit deren Ende zu verschiedenen Zeiten erreichen.

Es wird nicht ausgeschlossen, dass unter Gleichstromabscheidung mit Kappen 36 erzeugte Nanodraht-Arrays zur Herstellung eines stabilen Nanodraht-Strukturelements 1 verwendbar sind. Dennoch wurden weitere Versuche mit gepulster Abscheidung durchgeführt, um auch dort das Kappenwachstum zu untersuchen.

## Umkehrpulsabscheidung

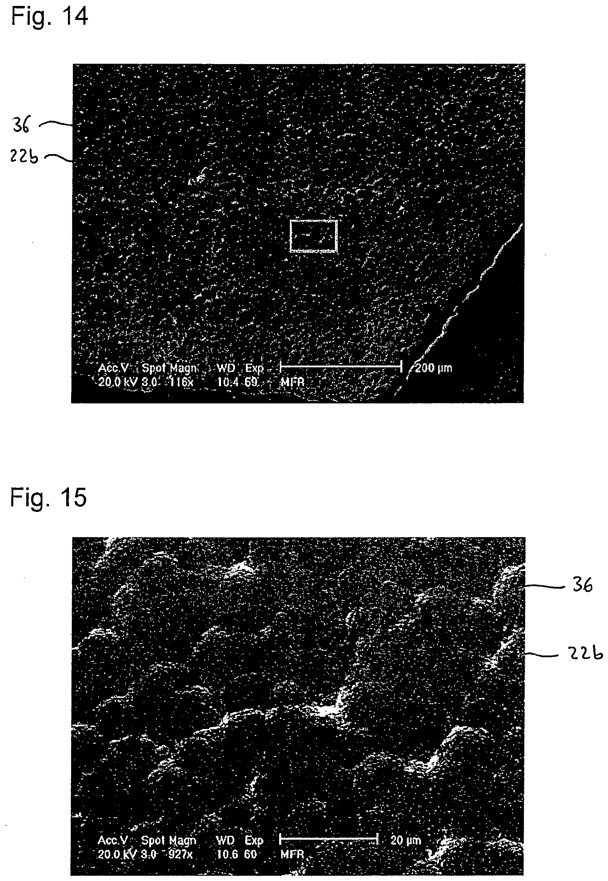

In den Fig. 14 und 15 ist ein unter Umkehrpulsabscheidung hergestelltes Platin-Nanodraht-Array 35 zu sehen. Die Kappen 36 sind zu einer dichten, geschlossenen Schicht 22b zusammengewachsen, was durch eine bessere Größenverteilung möglich wird, die mit der Umkehrpulsabscheidung erzielt wird. Die Schicht 22b ist über die gesamte Elektrodenoberfläche homogen und zeigt keine Lücken. Es ist zu beachten, dass auch bei diesem Versuch nach Ausbildung der Metallschicht 22b bestehend aus den vollständig zusammengewachsenen Kappen 36 der Abscheidevorgang der zweiten Deckschicht 26b nicht vollständig durchgeführt wurde, so dass die zweite Deckschicht 26b noch nicht vollständig ausgebildet ist, sondern die Metallschicht 22b bestehend aus den zusammengewachsenen Kappen 36 nur eine Teilschicht 22b der zweiten Deckschicht 26b darstellt.

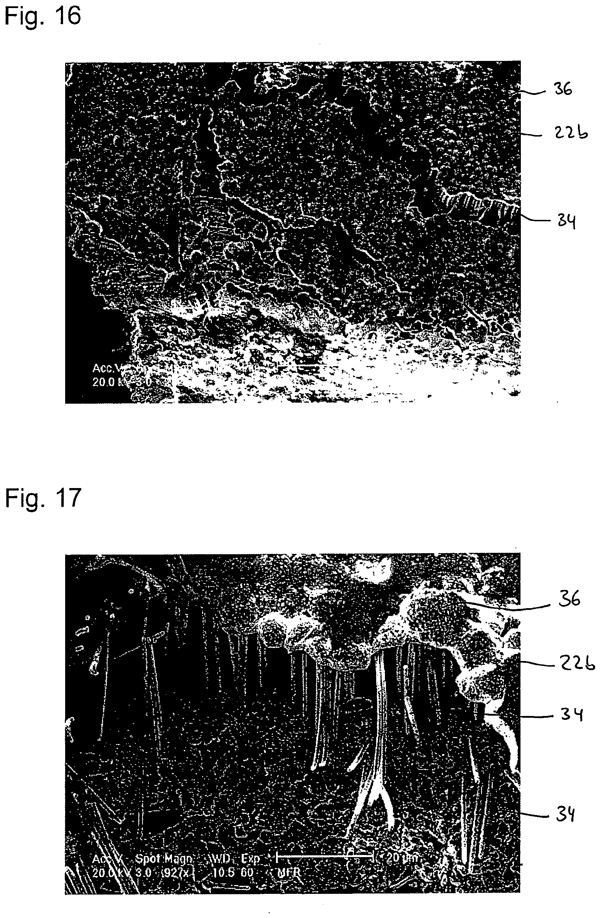

Wird dieses unfertige Array mechanischer Belastung ausgesetzt, indem z. B. mit einer Pinzette Druck ausgeübt wird, so zerreißt die aus den Kappen 36 gebildete Schicht 22b, wie in Fig. 16 dargestellt ist und ermöglicht einen Blick zwischen die Metalldeckschichten in das Innere des Arrays. Fig. 17 zeigt eine Ausschnittsvergrößerung einer aufgerissenen Stelle. Deutlich zu erkennen sind die parallel angeordneten Nanodrähte 34, die die Metallschichten, mit denen sie fest verbunden sind, auf gleich bleibendem Abstand zusammenhalten.

Die vorteilhaft engere Größenverteilung der Kappen 36 im Vergleich zur Gleichstromabscheidung kann ohne Anspruch auf Vollständigkeit und Richtigkeit durch die kürzere Diffusionsschicht erklärt werden. In den Pausen zwischen den Pulsen können Metallionen nachdiffundieren, sodass auf der gesamten Elektrodenoberfläche nahezu gleiche Konzentrationsverhältnisse zu Beginn eines jeden Abscheidungspulses vorliegen, was zu homogenem Wachstum führt. Die Diffusionsschichten überschneiden sich kaum und Unregelmäßigkeiten in der Oberfläche werden nicht verstärkt.

Zusammenfassend kann festgehalten werden, dass die gepulste Abscheidung der Nanodrähte 34 und der Kappen 36, insbesondere unter Umkehrpulsabscheidung ein hervorragend gleichmäßiges Kappenwachstum ermöglicht hat. Hierbei wird die elektrochemische Abscheidung zur Erzeugung der Nanodrähte 34 zumindest solange fortgeführt, bis sich Kappen 36 auf den Nanodrähten ausgebildet haben und diese zu einer flächig geschlossenen Schicht 22b zusammengewachsen sind. Anschließend wird entweder weiter elektrochemisch Material abgeschieden, um die Schicht 22b aus zusammengewachsenen Kappen 36 soweit zu verstärken, bis die stabile zweite Deckschicht 26b erzeugt ist, oder es wird in einem separaten Abscheidevorgang eine zweite Teilschicht 24b aufgebracht, in die die zusammengewachsenen Kappen 36 eingebettet werden. Zur Herstellung des erfindungsgemäßen stabilen Nanodraht-Strukturelements 1 wird die Templatfolie 12 insbesondere erst danach entfernt. Die Dicke der zweiten Deckschicht 26b sollte mindestens 1 $\mu$m betragen. Vorzugsweise ist die Dicke jedoch größer als 5 $\mu$m, z.B. zwischen 5 $\mu$m und 10 $\mu$m. Gleiches gilt für die erste Deckschicht 26a.

## Strukturelle Eigenschaften der Nanodrähte

Im Rahmen der Erfindung wurden auch die strukturellen Eigenschaften der Nanodrähte 34 aus verschiedenen Materialien untersucht. Bei elektrochemisch abgeschiedenem Material ist es z.B. möglich, die Größe der Kristallite zu kontrollieren. Dies hat Auswirkungen auf die mechanische Stabilität, die thermischen und elektrischen Transporteigenschaften sowie die Oberfläche und damit auch auf die katalytische Aktivität. Viele Eigenschaften können somit gezielt beeinflusst werden.

Insbesondere wurde die Struktur der Nanodrähte 34 mittels Röntgendiffraktion untersucht. Dazu wurde die Textur als Funktion der elektrochemischen Abscheidebedingungen analysiert.

Unter Gleichstrom hergestellte Pt-Nanodrähte 34 zeigen eine deutliche <100>-Textur. Der Texturkoeffizient $TC_{100}$ beträgt 2,32, wobei sein Maximalwert 3 ist. Die Größe der Kristallite wurde aus der Halbwertsbreite des Platin-Signals mit Hilfe der Scherrer-Formel bestimmt und betrug 8 nm. Für katalytische Anwendungen ist eine möglichst kleine Größe der Kristallite wünschenswert. Der hier angegebene Wert liegt in der Größenordnung der sonst in der Katalyse eingesetzten Nanopartikel. Es wird davon ausgegangen, dass die Kristallitgröße durch veränderte elektrochemische Abscheidebedingungen noch verkleinert werden kann.

Untersucht man Nanodrähte 34, die unter Pulsabscheidung hergestellt wurden, so findet man keine besondere Textur. Die Signalintensitäten entsprechen denen von polykristallinem Platin.

Schließlich ist eine Probe, die mit Umkehrpulsen hergestellt wurde, analysiert worden. Es zeigt sich erneut eine deutliche <100>-Textur, wobei der Texturkoeffizient $TC_{100}$ 4,16 ist. Die Kristallite weisen demnach eine bevorzugte Orientierung auf, wobei der Grad der Ausrichtung 83% beträgt. Eine Ausrichtung von mindestens 50% ist gegebenenfalls vorteilhaft.

Die Charakterisierung mittels Röntgendiffraktion von unterschiedlich hergestellten Nanodrähten 34 hat gezeigt, dass die Abscheidebedingungen Einfluss auf die Textur ausüben. Somit kann gezielt die Struktur der Nanodrähte beeinflusst werden. Es wird erwartet, dass sogar einkristalline Nanodrähte produziert werden können, wenn die Überspannung entsprechend niedrig gewählt wird.

Die Oberfläche eines Nanodrahtes 34 entspricht nicht der glatten Oberfläche eines Zylinders, auf welcher die Berechnung der geometrischen Oberfläche basiert, sondern zeigt zahlreiche Vertiefungen und Erhöhungen, die die Fläche stark vergrößern. Die tatsächliche Größe der Oberfläche ist also typischerweise größer als die geometrische Oberfläche, unter anderem da die Kristallite, aus denen die Nanodrähte 34 aufgebaut sind, sehr klein sind. Um genauere Vorstellungen von der Oberfläche der Nanodraht-Arrays 35 zu erhalten, wurden cyclovoltammetrische Messungen bei 60°C in 0,5 M $H_2SO_4$ im Potentialbereich von 0 bis 1300 mV bezogen auf eine Normalwasserstoffelektrode durchgeführt. Aus der Ladung, die bei der Adsorption von Wasserstoff übertragen wird, kann unter Berücksichtigung von kapazitiven Strömen die Elektrodenoberfläche berechnet werden. Die cyclovoltammetrischen Untersuchungen von Nanodraht-Array-Elektroden ergaben, dass die tatsächliche Oberfläche um den Faktor 4 bis 5 größer als die geometrische Oberfläche ist.

Anwendungen

Für einen Katalysator ist es möglich, einen Stapel aus einer Vielzahl der erfindungsgemäßen Nanodraht-Strukturelemente 1 zusammen zu schalten. Aufgrund der Abmessungen eignet sich das Nanodraht-Strukturelement 1 aber auch einzeln zum Einbau in mikrostrukturierte Systeme, welche dreidimensionale Strukturen sind, deren innere Abmessungen weniger als 1 mm betragen, meist zwischen zehn und wenigen hundert Mikrometern.

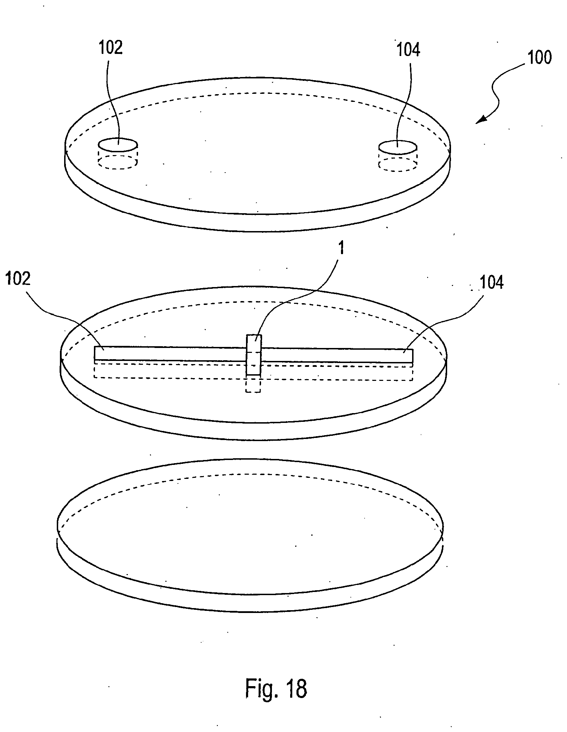

Fig. 18 zeigt schematisch einen Mikrokatalysator 100, in den zwischen einer Fluidzuführung 102 und einer Fluidabführung 104 ein erfindungsgemäßes Nanodraht-Strukturelement 1 eingesetzt ist. Es ist vorstellbar, in solch einem Mikrokatalysator 100 Gas- oder Flüssigphasenreaktionen ablaufen zu lassen. Dazu wird ein Gas- bzw. Flüssigkeitsstrom vorzugsweise mit Druck durch den Mikrokatalysator 100 geleitet.

Das erfindungsgemäß herstellbare Nanodraht-Strukturelement 1 beinhaltet ferner inhärent eine elektrische Kontaktierung aller zwischen den beiden Metallschichten angeordneten Nanodrähte. Dadurch kann eine kontrollierte Spannung an die Nanodrähte 34 angelegt werden und somit werden elektrokatalytische Prozesse ermöglicht. Zudem kann das Bauelement als amperometrischer Sensor verwendet werden.

Herstellung von Mikroelementen mit einer Bestrahlungsmaske

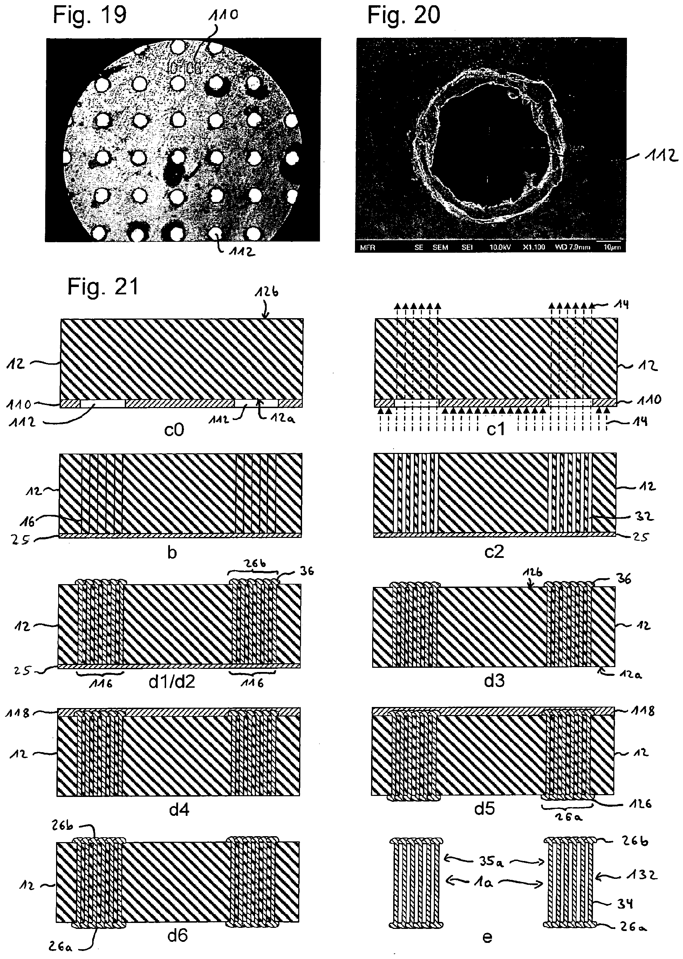

Erfindungsgemäß können beidseitig mit den beiden Deckschichten 26a, 26b geschlossene Nanodraht-Strukturelemente oder Nanodraht-Arrays mit sehr kleinen Abmessungen dadurch erzeugt werden, dass die Templatfolie 12, in diesem Beispiel eine Polymerfolie, durch eine entsprechende Maske 110 mit schweren Ionen bestrahlt wird (Schritt (c1) in Fig. 21). Die Maske 110, z.B. eine Lochmaske, die zuvor in Schritt (c0) aufgebracht wurde, besitzt eine Mehrzahl von Öffnungen 112 oder Bohrungen, wobei jede Öffnung 112 ein späteres Mikroelement 1a definiert. Die Maske 110 deckt bei der Bestrahlung die Templatfolie 12 ab und somit bilden sich latente Ionenspuren 16, die nachfolgend zu Nanoporen 32 aufgeätzt werden, nur in den nicht abgedeckten Bereichen, d.h. an den Öffnungen 112 der Maske 110. Der Grundriss und die Form der Mikroelemente 1a, wird also durch die Maske 110 vorgegeben.

Dieses Verfahren ist besonders zur Herstellung von vielen, sehr kleinen Nanodraht-Strukturelementen, wie gesagt in Form von Mikroelementen 1a geeignet. Die hiermit herstellbaren Mikroelemente 1a, bestehend aus zwei Deckschichten, die mit den Nanodrähten fest verwachsen sind, können einen Durchmesser von kleiner als 500 μm, insbesondere kleiner als 100 μm und ggf. sogar bis hinunter zu einigen Mikrometern aufweisen. Mit Durchmesser ist die Abmessung in der Ebene parallel zu den Deckschichten 26a, 26b oder quer zu den Nanodrähten 34 gemeint. Dabei kann z.B. das Aspektverhältnis von Durchmesser des Mikroelements zu Dicke des Mikroelements kleiner als 20:1 oder 5:1 betragen. Mit Dicke des Mikroelements ist die Abmessung quer zu der Ebene der Deckschichten 26a, 26b (in etwa der Abstand der beiden Deckschichten) gemeint.

Fig. 19 zeigt einen Ausschnitt einer beispielhaften Lochmaske 110 und Fig. 20 eine Vergrößerung eines Loches 112. Die Löcher 112 der Lochmaske 110 haben in diesem Beispiel einen Durchmesser von 50 $\mu$m, so dass nur in einem runden Bereich von 50 $\mu$m Durchmesser Nanodrähte 34 elektrochemisch abgeschieden werden und sich somit Mikroelemente 1a mit einem Durchmesser von etwa 50pm herstellen lassen.

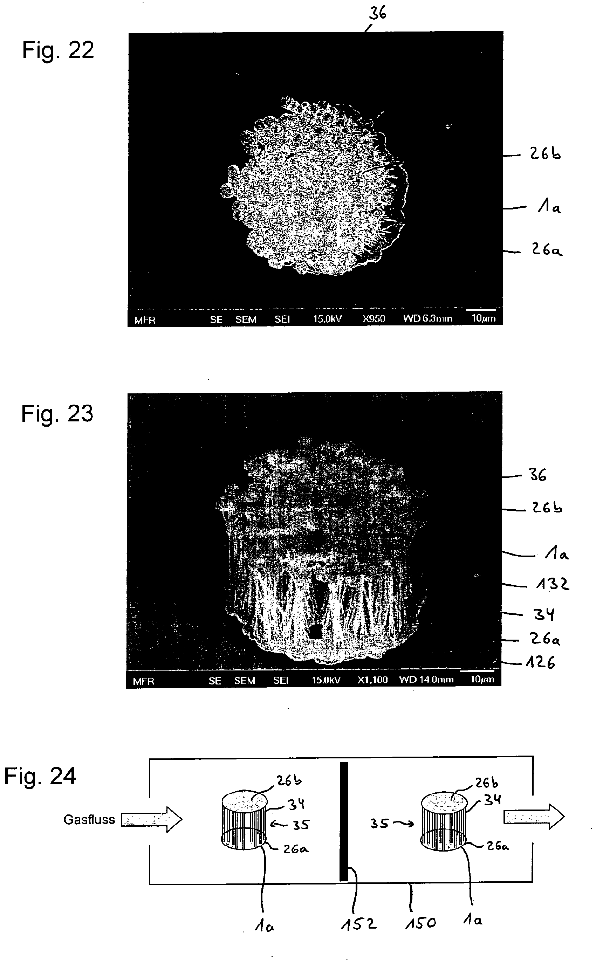

Die Fig. 22 und 23 zeigen eines der Vielzahl mit der Lochmaske 110 hergestellten Mikroelemente 1a mit einem Durchmesser von etwa 50$\mu$m und einer Dicke von etwa 30$\mu$m. Das Mikroelement 1a ist beidseitig mit flächig geschlossenen Deckschichten 26a, 26b versehen, die mit den Nanodrähten 34 verwachsen sind. Die geschlossenen Metallschichten 26a, 26b, die sich aus zusammengewachsenen Kappen 36, 126 auf beiden Seiten 12a, 12b der Templatfolie 12 gebildet haben, zeigen eine geringfügig größere Ausdehnung als das Nanodraht-Array 35a im Inneren. Die Bestrahlung wurde mit $10^8$ Ionen pro cm$^2$ durchgeführt. Folglich befinden sich zwischen den Metallschichten 26a, 26b des 50 $\mu$m großen Mikroelements 1a etwa 2000 Nanodrähte 34.

In diesem Beispiel ist die Lochmaske 110 zur IonenBestrahlung mit etwa 2000 Löchern 112 auf der gesamten Abscheidungsfläche von ungefähr 0,5 cm$^2$ versehen, so dass etwa 2000 Mikroelemente 1a mit Nanodraht-Arrays 35a wie Inseln 116 in der Templatfolie 12 auf einmal erzeugt werden konnten.

Diese Herstellung vieler Mikroelemente 1a mit Nanodraht-Arrays 35a in einer Templatfolie 12 ist aufwändiger als die eines die gesamte Abscheidungsfläche einnehmenden großen Nanodraht-Arrays 35, da zusätzliche Schritte durchgeführt werden.

Vor dem Aufätzen der latenten Ionenspuren 16 zu Nanoporen 32 wird auf die erste Seite 12a der Templatfolie 12 eine metallische Startschicht 25 aufgebracht. Die Startschicht 25 dient wiederum als temporäre Kathodenschicht für die Abscheidung der Nanodrähte 34. Diese Startschicht 25 wird wieder entfernt, nachdem sich die Kappen 36 auf der der Startschicht 25 gegenüberliegenden zweiten Seite 12b der Templatfolie 12 gebildet haben, damit die Mikroelemente 1a später getrennt werden können. Eine selektive Entfernung ist insbesondere dann möglich, wenn die Startschicht 25 aus einem anderen leitfähigen Material, insbesondere einem anderen Metall als die Nanodrähte 34 besteht.

Weiter werden die zuerst gebildeten Kappen 36, also diejenigen auf der zweiten Seite 12b der Templatfolie 12, mit einer selektiv entfernbaren, leitfähigen Schicht, ebenfalls vorzugsweise eine Metallschicht, überzogen, welche eine zweite temporäre Kathodenschicht 118 für die weitere Abscheidung bildet. Mittels der zweiten Kathodenschicht 118 werden die Nanodrähte 34 der Mehrzahl von inselartig verteilten Mikroelemente 1a über die Kappen 36 auf der zweiten Seite 12b elektrisch miteinander kontaktiert und es können nun auch auf der ersten Seite 12a der Templatfolie 12, auf der sich die Startschicht 25 befand, zweite Kappen 126 auf die Nanodrähte 34 aufwachsen. Wenn auch auf der ersten Seite 12a der Templatfolie 12 eine - hinreichend stabile - Metallschicht aus zusammengewachsenen zweiten Kappen 126 über den Nanodrähten 34 aufgewachsen ist, kann die zweite temporäre Kathodenschicht 118 auf der zweiten Seite 12b selektiv entfernt werden. Nachfolgend wird die Templatfolie 12, in diesem Beispiel eine Polymermatrix, aufgelöst und es entstehen vereinzelte Mikroelement-Nanodraht-Strukturelemente 1a in der Größe der Maskenlöcher 112 mit beidseitiger Deckschicht 26a, 26b jeweils aus zusammengewachsenen Kappen. Ein Beispiel eines derart hergestellten Mikroelement-Nanodraht-Strukturelemente 1a zeigen die Fig. 22 und 23, wobei in einem Arbeitsgang wie vorstehend beschrieben, eine Vielzahl dieser Mikroelement-Nanodraht-Strukturelemente 1a hergestellt wird.

Aus der Verwendung von Masken 110 zur Bestrahlung ergibt sich als Vorteil, dass die hergestellten Mikroelemente 1a mit Nanodrahtarrays 35a direkt zur Integration verwendet werden können, ohne weiter bearbeitet werden zu müssen. Die Nanodrahtarrays 35a der Mikroelemente 1a sind nämlich entlang des Umfangs 132 in der Ebene parallel zu den Deckschichten 26a, 26b offenzellig, wobei diese Offenzelligkeit bereits bei der Abscheidung erzeugt wird, so dass ein allseitig entlang des Umfangs 132 unbeschnittenes Mikroelement 1a mit Nanodrahtarray 35a erzeugt wird. Mechanische Belastungen z.B. durch Schneiden der Seitenflächen oder -kanten 134 können somit vermieden werden. In Fig. 22 und 23 ist zu sehen, dass die Deckschichten 26a, 26b aus zusammengewachsenen Kappen 126 bzw. 36 gebildet werden und dass diese am Rand etwas überstehen. Der Rand wird also durch die natürlich gewachsenen und zusammengewachsenen Kappen gebildet. Hieran kann man gut erkennen, dass das Mikroelement-Nanodraht-Strukturelement 1a mit diesem speziellen Verfahren hergestellt wurde und insbesondere, dass es am Rand unbeschnitten ist.

Da alle Nanodrähte 34 elektrisch auf beiden Seiten 12a, 12b kontaktiert sind, eignen sich die Mikroelemente 1a mit Nanodrahtarrays 35a besonders zur Produktion miniaturisierter Sensoren. Aus der großen Anzahl der Drähte sollte sich nicht nur ein hohe Empfindlichkeit, sondern auch eine hohe Defekttoleranz ergeben.

Fig. 24 zeigt ein Beispiel eines Sensors 150, z.B. zum Messen von Gasdurchfluss, Temperatur und als Bewegungssensor. Der Sensor 150 weist mindestens eine Messeinheit mit einem ersten und zweiten Mikroelement-Nanodraht-Strukturelement 1a auf, wobei die Mikroelement-Nanodraht-Strukturelemente 1a jeweils beidseits mit Deckschichten 26a, 26b versehen sind, wobei jedes der beiden Nanodraht-Strukturelemente 1a mittels einer oder beiden Deckschichten 26a, 26b elektrisch kontaktiert wird, wobei die beiden Nanodraht-Strukturelemente 1a separat kontaktiert werden. Zwischen den beiden Mikroelement-Nanodraht-Strukturelementen ist ein Heizelement, z.B. ein durch Anlegen einer Spannung heizbarer Mikrodraht 152, angeordnet. Die Änderung des Widerstandes des Sensorelementes 150 wird als Maß für den Gasdurchfluss oder die Temperaturänderung oder eine Bewegungsänderung verwendet.

Es ist dem Fachmann ersichtlich, dass die vorstehend beschriebenen Ausführungsformen beispielhaft zu verstehen sind, und die Erfindung nicht auf diese beschränkt ist, sondern in vielfältiger Weise variiert werden kann, ohne den Umfang der Ansprüche zu verlassen. Insbesondere ist die Herstellung eines Mikrokatalysators nur eines von vielen Anwendungsgebieten für das erfindungsgemäße Nanodraht-Strukturelement.

**Patentansprüche**

1. Verfahren zur Herstellung eines Nanodraht-Strukturelements (1), mit einem zwischen zwei Deckschichten (26a, 26b) angeordneten Nanodraht-Array (35) zur Bildung einer säulenartig von den Nanodrähten (34) durchsetzten Hohlraumstruktur (42), umfassend:

(a) Bereitstellen einer Templatfolie (12),
(b) Aufbringen einer ersten flächig geschlossenen elektrisch leitfähigen Deckschicht (26a) auf einer ersten Seite (12a) der Templatfolie (12),
(c) Erzeugen einer Vielzahl von Nanoporen (32) in der Templatfolie (12),
(d1) Erzeugen von Nanodrähten (34) in den Nanoporen (32), indem die Nanoporen (32) mittels elektrochemischer Abscheidung eines elektrisch leitfähigen Materials aufgefüllt werden, wobei die Nanodrähte (34) innerhalb der Nanoporen (32) auf die erste Deckschicht (26a) aufwachsen, und wobei die Nanodrähte einen Durchmesser von kleiner oder gleich 2000 nm aufweisen,
(d2) Erzeugen einer zweiten flächig geschlossenen Deckschicht (26b) auf der zweiten Seite (12b) der Templatfolie (12), so dass eine sandwichartige Anordnung aus den beiden Deckschichten (26a, 26b) und der von den Nanodrähten (34) durchsetzten Templatfolie (12) entsteht,
(e) Freilegen des strukturierten Hohlraums (42) zwischen den beiden Deckschichten (26a, 26b) durch Auflösen der Templatfolie (12) und Entfernen des aufgelösten Templatmaterials zwischen den beiden Deckschichten (26a, 26b), wobei die beiden Deckschichten erhalten bleiben,

wobei

die Schritte (d1) und (d2) als Teilschritte desselben elektrochemischen Abscheidevorgangs durchgeführt werden, indem der elektrochemische Abscheidevorgang nach dem vollständigen Auffüllen der Nanoporen (32) gemäß Teilschritt (d1) solange fortgeführt wird, bis die zweite Deckschicht (26b) vollständig ausgebildet ist, wobei auf der zweiten Seite (12b) der Templatfolie (12) Kappen (36) auf den Nanodrähten (34) wachsen und die Kappen (36) zu einer flächig geschlossenen Schicht zusammenwachsen und diese flächig geschlossene Schicht bis zur vollständigen Ausbildung der stabilen zweiten Deckschicht (26b) weiter wächst, so dass die Nanodrähte (34) und die zweite Deckschicht (26b) als eine einstückige Struktur gewachsen sind oder

der elektrochemische Abscheidevorgang gemäß Teilschritt (d1) solange fortgeführt wird, bis auf der zweiten Seite (12b) der Templatfolie (12) Kappen (36) auf den Nanodrähten (34) wachsen und die Kappen (36) zumindest teilweise zusammenwachsen und in einem weiteren nachfolgenden Abscheidevorgang eine flächig geschlossene Schicht (24b) auf den zumindest teilweise zusammengewachsenen Kappen (36) abgeschieden wird, wobei die stabile zweite Deckschicht (26b) aus den zumindest teilweise zusammengewachsenen Kappen (36) und der flächig geschlossenen Schicht (24b) entsteht.

2. Verfahren nach Anspruch 1, wobei das Aufbringen der ersten Deckschicht (26a) gemäß Schritt (b) folgende Teilschritte umfasst:

(b1) Abscheiden einer ersten Teilschicht (22a) mittels PVD und
(b2) Verstärken der ersten Teilschicht (22a) mittels elektrochemischer Abscheidung einer zweiten Teilschicht (24a) auf der ersten Teilschicht (22a).

3. Verfahren nach einem der vorstehenden Ansprüche,

wobei Schritt (a) ferner den Schritt umfasst:
(a1) Bestrahlen der Templatfolie (12) mit energetischer Strahlung (14) zur Erzeugung einer Vielzahl, die Templatfolie durchsetzender latenter Spuren (16),
und
wobei Schritt (c) umfasst:
(c2) Erzeugen der Nanoporen (32) in der Templatfolie (12), indem die strahlungsinduzierten latenten Spuren (16) mittels eines Ätzverfahrens aufgeweitet werden.

**4.** Verfahren nach einem der Ansprüche 1 oder 2, wobei Schritt (c) folgende Teilschritte umfasst:

> (c1) Bereitstellen einer Aluminiumfolie als Templatfolie (12) und
> (c2) Erzeugen der Nanoporen (32) in der Aluminiumfolie durch Anodisieren.

**5.** Nanodraht-Strukturelement (1) mit Hohlraumstruktur (42) herstellbar mit dem Verfahren nach einem der vorstehenden Ansprüche, umfassend:

> ein Array (35) aus einer Vielzahl von nebeneinander angeordneten Nanodrähten (34) und zwei beabstandete Deckschichten (26a, 26b), wobei sich die Nanodrähte (34) quer zwischen den beiden Deckschichten (26a, 26b) erstrecken und die Nanodrähte (34) mit ihrem ersten Ende (34a) mit der ersten Deckschicht (26a) und mit ihrem zweiten Ende (34b) mit der zweiten Deckschicht (26b) fest verbunden sind, so dass die Nanodrähte (34) die beiden Deckschichten (26a, 26b) fest miteinander verbinden und den Abstand zwischen den beiden Deckschichten (26a, 26b) definieren,
> wobei zwischen den Nanodrähten (34) miteinander verbundene Zwischenräume vorhanden sind und wobei die Nanodrähte einen Durchmesser von kleiner oder gleich 2000 nm aufweisen,
> so dass eine stabile sandwichartige Nanostruktur mit einer zweiseitig von den Deckschichten (26a, 26b) begrenzten und von der Vielzahl von Nanodrähten (34) säulenartig durchsetzten und in der Ebene parallel zu den Deckschichten (26a, 26b) zweidimensional offenzellige Hohlraumstruktur (42) definiert wird, derart dass zwischen den beiden Deckschichten (26a, 26b) ein Fluid durch die zweidimensional offenzellige Hohlraumstruktur (42) geleitet werden kann.

**6.** Nanodraht-Strukturelement (1) nach Anspruch 5, wobei die erste der beiden Deckschichten (26a) zumindest zweischichtig ausgebildet ist.

**7.** Nanodraht-Strukturelement (1) nach einem der vorstehenden Ansprüche, wobei die zweite Deckschicht (26b) eine zweite Teilschicht (24b) auf der ersten Teilschicht (22b) umfasst.

**8.** Nanodraht-Strukturelement (1) nach einem der vorstehenden Ansprüche, wobei die Nanodrähte (34) eine kristallitische Textur oder eine einkristalline Struktur aufweisen.

**9.** Nanodraht-Strukturelement (1) nach einem der vorstehenden Ansprüche, wobei an zumindest einer Stirnseite (28) des Nanostrukturelements (1) zumindest eine der beiden Deckschichten (26a, 26b) um die Stirnseite (28) herumgezogen und mit der anderen Deckschicht verbunden ist, so dass die Stirnseite (28) verschlossen ist.

**10.** Mikroreaktorsystem, umfassend:

> ein mikrostrukturiertes Kanalsystem mit einer Fluidzuführung und einer Fluidabführung, zumindest ein Nanodraht-Strukturelement (1) gemäß einem der Ansprüche 5 bis 9 als Reaktorelement zwischen der Fluidzuführung und der Fluidabführung,
> derart dass Fluid aus der Fluidzuführung in die Hohlraumstruktur (42) zwischen den beiden Deckschichten (26a, 26b) eingeleitet, durch die Zwischenräume zwischen den Nanodrähten (34) hindurch geleitet und durch die Fluidabführung wieder aus der Hohlraumstruktur (42) abgeführt werden kann,
> wobei die zweidimensional offenzellige Hohlraumstruktur (42) des Nanodraht-Strukturelements (1) zwischen den beiden Deckschichten (26a, 26b) das Reaktionsvolumen bildet und die Zylinderflächen der Nanodrähte (34) die aktive Oberfläche bilden, mit der das Fluid innerhalb der Hohlraumstruktur (42) während des Durchfließens wechselwirkt.

**11.** Katalysatorsystem, umfassend:

> ein mikrostrukturiertes Kanalsystem mit einer Fluidzuführung und einer Fluidabführung, zumindest ein Nanodraht-Strukturelement (1) gemäß einem der Ansprüche 5 bis 9 als Katalysatorelement zwischen der Fluidzuführung und der Fluidabführung,
> derart dass Fluid aus der Fluidzuführung in die Hohlraumstruktur (42) zwischen den beiden Deckschichten (26a, 26b) eingeleitet, durch die Zwischenräume zwischen den Nanodrähten (34) hindurch geleitet und durch die Fluidabführung wieder aus der Hohlraumstruktur (42) abgeführt werden kann,
> wobei die zweidimensional offenzellige Hohlraumstruktur (42) des Nanodraht-Strukturelements (1) zwischen den beiden Deckschichten (26a, 26b) das katalytische Reaktionsvolumen bildet und die Zylinderflächen der Nanodrähte (34) die katalytisch aktive Oberfläche bilden, mit der das Fluid innerhalb der Hohlraumstruktur (42) während des Durchfließens wechselwirkt.

**12.** Sensorelement (150), insbesondere zum Messen von Gasdurchfluss, Temperatur oder Bewegung, aufweisend:
mindestens eine Messeinheit mit einem ersten Nanodraht-Strukturelement (1, 1a) und einem zweiten Nanodraht-Strukturelement (1, 1a) gemäß einem der Ansprüche 5 bis 9, wobei die Nanodraht-Strukturelemente (1, 1a) jeweils beidseitig mit den Nanodrähten (34) verbundene Deckschichten (26a, 26b) zum Kontaktieren des jeweiligen Nanodraht-Strukturelements aufweisen und wobei zwischen den Nanodraht-Strukturelementen ein Heizelement (152) angeordnet ist.

**Claims**

1. A method for producing a nanowire structural element (1) comprising a nanowire array (35) arranged between two cover layers (26a, 26b) to form a cavity structure (42) permeated by the nanowires (34) in a columnar manner, comprising:

   (a) providing a template film (12);
   (b) depositing a first electrically conductive full-surface contiguous cover layer (26a) on a first side (12a) of the template film (12);
   (c) producing a multitude of nanopores (32) in said template film (12);
   (d1) producing nanowires (34) in said nanopores (32) by filling the nanopores (32) by electrochemical deposition of an electrically conductive material, wherein the nanowires (34) grow inside the nanopores (32) on the first cover layer (26a), and wherein the nanowires have a diameter of less than or equal to 2000 nm;
   (d2) producing a second full-surface contiguous cover layer (26b) on the second side (12b) of the template film (12), so as to create a sandwich-like arrangement consisting of the two cover layers (26a, 26b) and the template film (12) permeated by the nanowires (34);
   (e) exposing the cavity structure (42) between the two cover layers (26a, 26b) by dissolving the template film (12) and removing the dissolved template material between the two cover layers (26a, 26b), while the two cover layers remain intact;

   wherein steps (d1) and (d2) are performed as sub-steps of the same electrochemical deposition process, by continuing the electrochemical deposition process after the nanopores (32) have been completely filled in accordance with sub-step (d1) until the second cover layer (26b) is completed, by having caps (36) growing on the nanowires (34) on the second side (12b) of the template film (12) and the caps (36) growing together to form a flat full-surface contiguous layer and this flat full-surface contiguous layer continuing to grow until the stable second cover layer (26b) is completed, so that the nanowires (34) and the second cover layer (26b) are grown as an integral structure; or wherein the electrochemical deposition process according to sub-step (d1) is continued until caps (36) grow on the nanowires (34) on the second side (12b) of the template film (12) and the caps (36) grow together at least partially, and in a further, subsequent deposition process, a full-surface contiguous layer (24b) is deposited on top of the caps (36) that have at least partially grown together, with the stable second cover layer (26b) being formed from the caps (36) that have at least partially grown together and the full-surface contiguous layer (24b).

2. The method according to claim 1, wherein the depositing of the first cover layer (26a) according to step (b) comprises the following sub-steps:

   (b1) depositing a first sublayer (22a) using PVD; and
   (b2) reinforcing the first sublayer (22a) by electrochemically depositing a second sublayer (24a) on top of the first sublayer (22a).

3. The method according to any one of the preceding claims,

   wherein step (a) further comprises the step of:
   (a1) irradiating the template film (12) with energetic radiation (14) to generate a multitude of latent traces (16) permeating the template film; and
   wherein step (c) comprises: (c2) producing the nanopores (32) in the template film (12) by widening the radiation-induced latent traces (16) by an etching process.

4. The method according to any one of claims 1 or 2, wherein step (c) comprises the following sub-steps:

   (c1) providing an aluminium foil as the template film (12); and
   (c2) producing the nanopores (32) in the aluminium foil by anodizing.

5. A nanowire structural element (1) comprising a cavity structure (42), producible by the method according to any one of the preceding claims, comprising:

   an array (35) consisting of a multitude of nanowires (34) that are arranged next to one another; and
   two spaced-apart cover layers (26a, 26b);
   wherein the nanowires (34) extend transversely between the two cover layers (26a, 26b) and wherein the nanowires (34) are firmly bonded with their first end (34a) to the first cover layer (26a) and with their second end (34b) to the second cover layer (26b), so that the nanowires (34) firmly connect the two cover layers (26a, 26b) to one another and define the spacing between the two cover layers (26a, 26b);

wherein there are interconnected open spaces between the nanowires (34) and wherein the nanowires have a diameter of less than or equal to 2000 nm;

so that a stable sandwich-like nanostructure is defined, consisting of a cavity structure (42) having two-dimensionally open cells in the plane parallel to the cover layers (26a, 26b) and being permeated by said multitude of nanowires (34) in a columnar manner and delimited on either side by the cover layers (26a, 26b), such that a fluid can be directed through the two-dimensional open-cell cavity structure (42) between the two cover layers (26a, 26b).

6. The nanowire structural element (1) according to claim 5, wherein the first one of the two cover layers (26a) consists of at least two layers.

7. The nanowire structural element (1) according to any one of the preceding claims, wherein the second cover layer (26b) comprises a second sublayer (24b) on the first sublayer (22b).

8. The nanowire structural element (1) according to any one of the preceding claims, wherein the nanowires (34) have a crystallite texture or a monocrystalline structure.

9. The nanowire structural element (1) according to any one of the preceding claims, wherein on at least one end face (28) of the nanostructural element (1) at least one of the two cover layers (26a, 26b) is drawn around the end face (28) and joined to the other cover layer so that the end face (28) is enclosed.

10. A microreactor system, comprising:

a microstructured channel system having a fluid inlet and a fluid outlet;
at least one nanowire structural element (1) according to any one of claims 5 to 9 as a reactor element between the fluid inlet and the fluid outlet,
such that fluid from the fluid inlet can be introduced into the cavity structure (42) between the two cover layers (26a, 26b), can be passed through the open spaces between the nanowires (34), and can be discharged again from the cavity structure (42) through the fluid outlet;
wherein the two-dimensional open-cell cavity structure (42) of the nanowire structural element (1) defines the reaction volume between the two cover layers (26a, 26b) and the cylindrical surfaces of the nanowires (34) provide the active surface area with which the fluid interacts inside the cavity structure (42) while flowing therethrough.

11. A catalyst system, comprising:

a microstructured channel system having a fluid inlet and a fluid outlet;
at least one nanowire structural element (1) according to any one of claims 5 to 9 as a catalyst element between the fluid inlet and the fluid outlet;
such that fluid from the fluid inlet can be introduced into the cavity structure (42) between the two cover layers (26a, 26b), can be passed through the open spaces between the nanowires (34), and can be discharged again from the cavity structure (42) through the fluid outlet;
wherein the two-dimensional open-cell cavity structure (42) of the nanowire structural element (1) defines the catalytic reaction volume between the two cover layers (26a, 26b) and the cylindrical surfaces of the nanowires (34) provide the catalytically active surface area with which the fluid interacts inside the cavity structure (42) while flowing therethrough.

12. A sensor element (150), in particular for measuring gas flow, temperature or movement, comprising:
at least one measurement unit including a first nanowire structural element (1, 1a) and a second nanowire structural element (1, 1a) according to any one of claims 5 to 9, wherein each of the nanowire structural elements (1, 1a) has cover layers (26a, 26b) on either side connected to the nanowires (34) for electrically connecting the respective nanowire structural element, and wherein a heating element (152) is arranged between the nanowire structural elements.

**Revendications**

1. Procédé de fabrication d'un élément de structure (1) à nano-fils, comprenant un réseau (35) de nano-fils disposé entre deux couches de couverture (26a, 26b) pour la formation d'une structure creuse (42) traversée par les nano-fils (34) à la manière de piliers, lequel procédé comporte les étapes suivantes :

a) prendre une feuille-patron (12),
b) déposer, sur un premier côté (12a) de la feuille-patron (12), une première couche de couverture (26a), électroconductrice et sans vide en surface,

c) former une multitude de nanopores (32) dans la feuille-patron (12),

d1) former des nano-fils (34) dans les nanopores (32), en remplissant les nanopores (32), par dépôt électrochimique, d'un matériau électroconducteur, au cours de quoi les nano-fils (34) croissent à l'intérieur des nanopores (32) sur la première couche de couverture (26a), lesquels nano-fils présentent un diamètre inférieur ou égal à 2000 nm,

d2) former une deuxième couche de couverture (26b), sans vide en surface, sur le deuxième côté (12b) de la feuille-patron (12), de manière à ce qu'il se forme un ensemble arrangé de type sandwich, constitué par les deux couches de couverture (26a, 26b) et la feuille-patron (12) traversée par les nano-fils (34),

e) et dégager un espace creux structuré (42) entre les deux couches de couverture (26a, 26b), en dissolvant la feuille-patron (12) et en chassant le matériau de feuille-patron dissous d'entre les deux couches de couverture (26a, 26b), ces deux couches de couverture étant conservées,

étant entendu

que les étapes (d1) et (d2) sont réalisées comme faisant partie d'un même processus de dépôt électrochimique, en ce sens que ce processus de dépôt électrochimique, une fois les nanopores (32) complètement remplis dans l'étape (d1), est poursuivi jusqu'à ce que la deuxième couche de couverture (26b) soit complètement formée, au cours de quoi, sur le deuxième côté (12b) de la feuille-patron (12), des coiffes (36) croissent sur les nano-fils (34) et ces coiffes (36), tout en croissant, s'unissent en une couche sans vide en surface, et cette couche sans vide en surface croît encore jusqu'à la formation complète de la deuxième couche de couverture (26b) stable, de sorte que les nano-fils (34) et la deuxième couche de couverture (26) forment une structure d'un seul tenant,

ou que le processus de dépôt électrochimique de l'étape partielle (d1) est mené jusqu'à ce que, sur le deuxième côté (12b) de la feuille-patron (12), des coiffes (36) croissent sur les nano-fils (34) et ces coiffes (36), tout en croissant, s'unissent au moins partiellement, et dans un autre processus ultérieur de dépôt, une couche sans vide en surface (24b) est déposée sur les coiffes (36) au moins partiellement unies pendant leur croissance, la deuxième couche de couverture (26b) stable étant alors formée des coiffes (36) au moins partiellement unies pendant leur croissance et de la couche (24b) sans vide en surface.

2. Procédé conforme à la revendication 1, dans lequel le dépôt de la première couche de couverture (26a) de l'étape (b) comporte les étapes partielles suivantes :

b1) déposer par PVD une première couche partielle (22a),

b2) et renforcer cette première couche partielle (22a) par dépôt électrochimique d'une deuxième couche partielle (24a) sur cette première couche partielle (22a).

3. Procédé conforme à l'une des revendications précédentes, dans lequel l'étape (a) comprend en outre l'étape suivante :

a1) irradier la feuille-patron (12) avec un rayonnement énergétique (14), pour y produire un grand nombre de traces latentes (16) qui traversent la feuille-patron,

et l'étape (c) comprend l'étape suivante :

c2) produire des nanopores (32) dans la feuille-patron (12), en élargissant par mordançage les traces latentes (16) produites par irradiation.

4. Procédé conforme à l'une des revendications 1 et 2, dans lequel l'étape (c) comporte les étapes partielles suivantes :

c1) prendre, en tant que feuille-patron (12), une feuille d'aluminium,

c2) et produire, par anodisation, des nanopores (32) dans cette feuille d'aluminium.

5. Elément de structure (1) à nano-fils et doté d'une structure creuse (42), accessible par un procédé conforme à l'une des revendications précédentes, et comprenant :

- un réseau (35) constitué d'une multitude de nano-fils (34) disposés les uns à côté des autres,
- et deux couches de couverture (26a, 26b), écartées l'une de l'autre,

dans lequel les nano-fils (34) s'étirent transversalement entre les deux couches de couverture (26a, 26b) et les nano-fils (34) sont solidement fixés, par leur première extrémité (34a), à la première couche de couverture (26a), et par leur deuxième extrémité (34b), à la deuxième couche de couverture (26b), de sorte que les nano-fils (34) relient solidement l'une à l'autre les deux couches de couverture (26a, 26b) et définissent l'écartement existant entre ces deux couches de couverture (26a, 26b),

dans lequel il existe, entre les nano-fils (34), des vides reliés les uns aux autres, et dans lequel les nano-fils présentent un diamètre inférieur ou égal à 2000 nm,

de sorte qu'est définie une nanostructure stable de type sandwich, avec une structure creuse (42), délimitée des deux côtés par les couches de couverture (26a, 26b), traversée par la multitude de nano-fils (34) à la manière de piliers, et à alvéoles ouvertes dans deux dimensions dans le plan parallèle aux couches de couverture (26a, 26b),

si bien qu'entre les deux couches de couverture (26a, 26b), on peut faire passer un fluide dans la structure creuse à alvéoles ouvertes dans deux dimensions.

**6.** Elément de structure (1) à nano-fils, conforme à la revendi-cation 5, dans lequel la première (26a) des deux couches de couverture est constituée d'au moins deux couches.

**7.** Elément de structure (1) à nano-fils, conforme à l'une des revendications précédentes, dans lequel la deuxième couche de couver-ture (26b) comprend une deuxième couche partielle (24b) par-dessus la première couche partielle (22b).

**8.** Elément de structure (1) à nano-fils, conforme à l'une des revendications précédentes, dans lequel les nano-fils (34) présentent une texture à cristallites ou une structure monocristalline.

**9.** Elément de structure (1) à nano-fils, conforme à l'une des revendications précédentes, dans lequel, sur au moins un côté de front (28) de l'élément de nanostructure (1), au moins l'une des deux cou-ches de couverture (26a, 26b), est tirée autour du côté de front (28) et reliée à l'autre couche de couverture, de sorte que le côté de front (28) est fermé.

**10.** Système de microréacteur, comprenant :

- un système de canalisation à microstructure, doté d'une entrée de fluide et d'une sortie de fluide,
- au moins un élément de structure (1) à nano-fils, conforme à l'une des revendications 5 à 9, comme élément de réacteur situé entre l'entrée de fluide et la sortie de fluide,
- de sorte qu'un fluide puisse être introduit par l'entrée de fluide dans la structure creuse (42) entre les deux couches de couverture (26a, 26b), conduit à travers les vides entre les nano-fils (34) et reconduit hors de la structure creuse (42) par la sortie de fluide,

dans lequel la structure creuse (42), à alvéoles ouvertes dans deux dimensions, de l'élément de structure (1) à nano-fils, entre les deux couches de couverture (26a, 26b), constitue le volume réactionnel, et les surfaces cylindriques des nano-fils (34) constituent la surface active avec laquelle le fluide interagit pendant son parcours à l'inté-rieur de la structure creuse (42).

**11.** Système catalyseur comprenant :

- un système de canalisation à microstructure, doté d'une entrée de fluide et d'une sortie de fluide,
- au moins un élément de structure (1) à nano-fils, conforme à l'une des revendications 5 à 9, comme élément catalyseur placé entre l'entrée de fluide et la sortie de fluide,
- de sorte qu'un fluide puisse être introduit par l'entrée de fluide dans la structure creuse (42) entre les deux couches de couverture (26a, 26b), conduit à travers les vides entre les nano-fils (34) et reconduit hors de la structure creuse (42) par la sortie de fluide,

dans lequel la structure creuse (42), à alvéoles ouvertes dans deux dimensions, de l'élément de structure (1) à nano-fils, entre les deux couches de couverture (26a, 26b), constitue le volume réactionnel catalytique et les surfaces cylindriques des nano-fils (34) constituent la surface catalytiquement active avec laquelle le fluide interagit pendant son parcours à l'intérieur de la structure creuse (42).

**12.** Elément capteur (150), destiné en particulier à la mesure d'un débit de gaz, d'une température ou d'un mouvement, comportant :
au moins une unité de mesure comprenant un premier élément de structure (1, 1a) à nano-fils et un deuxième élément de structure (1, 1a) à nano-fils, conformes à l'une des revendications 5 à 9, dans laquelle ces éléments de structure (1, 1a) à nano-fils comportent chacun, des deux côtés, des couches de couverture (26a, 26b) reliées aux nano-fils (34) pour établir le contact de l'élément de structure à nano-fils res-pectif, et dans laquelle un élément chauffant (152) est disposé entre les éléments de structure à nano-fils.

Fig. 1

Fig. 2

Fig. 3

Fig. 4

Fig. 5

Fig. 6

Fig. 7

## Fig. 8

## Fig. 9

Fig. 10

Fig. 11

Fig. 12

Fig. 13

36

## Fig. 14

## Fig. 15

Fig. 16

Fig. 17

Fig. 18

Fig. 19

Fig. 20

Fig. 21

Fig. 22

Fig. 23

Fig. 24

Gasfluss

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2006134392 A1

**In der Beschreibung aufgeführte Nicht-Patentliteratur**

- **K. JÄHNISCH et al.** Chemistry in Microstructured Reactors. *Ang. Chem. Int. Ed.,* 2004, vol. 43, 406-446
- **O. WÖRZ et al.** Microreactors - a New Efficient Tool for Reactor Development. *Chem. Eng. Technol.,* 2001, vol. 24, 138-142
- **M. FICHTNER.** Microstructured Rhodium Catalysts for the Partial Oxidation of Methane to Syngas under Pressure. *Ind. Eng. Chem. Res.,* 2001, vol. 40, 3475-3483
- **G. VESER.** Experimental and Theoretical Investigation of H2 Oxidation in a High-Temperature Catalytic Microreactor. *Chem. Eng. Sci.,* 2001, vol. 56, 1265-1273
- **R. NARAYANAN et al.** Catalysis with Transition Metal Nanoparticles in Colloidal Solution: Nanoparticle Shape Dependence and Stability. *J. Chem. Phys. B,* 2005, vol. 109, 12663-12676
- **Z. CHEN et al.** Supportless Pt and PtPd Nanotubes as Electrocatalysts for Oxygen-Reduction Reactions. *Angew. Chem.,* 2007, vol. 119, 4138-4141
- **J. H. YUAN et al.** Highly ordered Platinum-Nanotubule Arrays for Amperometric Glucose Sensing. *Adv. Funct. Mater,* 2005, vol. 15, 803
- **H. WANG et al.** Pd nanowire arrays as electrocatalysts for ethanol electrooxidation. *Electrochem. Commun.,* 2007, vol. 9, 1212-1216
- **H. M. ZHANG et al.** novel electrocatalytic activity in layered Ni-Cu nanowire arrays. *Chem. Commun.,* 2003, 3022
- **NIELSCH et al.** Uniform Nickel Deposition into ordered Alumina pores by pulsed electrodeposition. *Adv. Mater.,* 2000, vol. 12, 582-586
- **M. LINDEBERG.** A comprehensive study of ion track enabled high aspect ratio microstructures in flexible circuit boards. *MICROSYSTEM TECHNOLOGIES, BERLIN, DE,* 01. Januar 2004, vol. 10, 608-621
- Interconnected nanowire clusters in polyimide for flexible circuits and magnetic sensing applications. SENSORS AND ACTUATORS A: PHYSICAL. ELSEVIER, 15. Juli 2003, vol. 105, 150-161
- **T. W. CORNELIUS et al.** Controlled fabrication of poly- and single-crystalline bismuth nanowires. *Nanotechnology,* 2005, vol. 16, 246-249
- **A.P. LI et al.** Hexagonal Pore Arrays with a 50-420 nm Interpore Distance Formed by Self-Organization in Anodic Alumina. *Journal of Applied Physics,* 1998, vol. 84-11, 6023-6026